# EUROPEAN PATENT APPLICATION

(11) **EP 4 696 546 A1**
(43) Date of publication of application: **18.02.2026**
(21) Application number: 25191544.3
(22) Date of filing: 24.07.2025
(51) Int. Cl.: B60L 53/18, B60H 1/00, B60L 53/302

(54) **LIQUID COOLING DEVICE AND CHARGING PILE**

(30) Priority: 24.07.2024 CN 202411001524
(71) Applicant: HUAWEI DIGITAL POWER TECHNOLOGIES CO., LTD., Shenzhen Guangdong 518043 (CN)
(72) Inventor: SONG, Jinliang, Shenzhen, 518043 (CN); HU, Minggui, Shenzhen, 518043 (CN)
(74) Representative: Isarpatent

(57) **Abstract**

Embodiments of this application provide a liquid cooling device and a charging pile. The liquid cooling device includes a first compressor, a first heat exchanger, a first expansion valve, and a second heat exchanger that are sequentially connected. The first heat exchanger includes a first refrigerant path and a first coolant path, the first refrigerant path is connected between the first compressor and the first expansion valve, and the first refrigerant path is configured to exchange heat with the first coolant path. A liquid outlet of the first coolant path is configured to connect to a liquid injection port of an electric vehicle and a liquid inlet of a liquid cooling channel of a charger, and a liquid inlet of the first coolant path is configured to connect to a liquid return port of the electric vehicle, to provide coolant for the electric vehicle and the liquid cooling channel of the charger.

## Description

### TECHNICAL FIELD

This application relates to the charging field, and more specifically, to a liquid cooling device and a charging pile.

### BACKGROUND

With acceleration of a process of a carbon peaking and carbon neutrality strategy and an increase in a popularization rate of electric vehicles, an increasing quantity of cities have begun to build ultra-fast charging cities. This drives development of a charging device toward a high-power ultra-fast charging device, to quickly supplement energy for the electric vehicle with "one kilometer of driving range per second", and achieve brand-new charging experience of "Charge up while you coffee up".

During actual application, the charging device transmits charging power to a power battery of the electric vehicle via a charger. However, as the charging power continuously increases, heat generated by a charging cable of the charger and the power battery of the electric vehicle greatly increases. Consequently, temperatures of the charger and the power battery continuously increase in a high-power charging process of the electric vehicle. However, an excessively high temperature is likely to cause a decrease in efficiency and safety of charging the electric vehicle by the charging device, and consequently affects normal high-power charging of the electric vehicle by the charging device.

### SUMMARY

This application provides a liquid cooling device and a charging pile. The liquid cooling device may separately provide coolant for a liquid cooling channel of a charger and an electric vehicle, to dissipate heat for a charging cable of the charger and a power battery of the electric vehicle. In this way, heat dissipation requirements of both the charger and the electric vehicle during high-power charging can be met, efficiency and safety of charging the electric vehicle by the charging pile are improved, and the liquid cooling device can have high utilization.

According to a first aspect, a liquid cooling device is provided. The liquid cooling device includes a first compressor, a first heat exchanger, a first expansion valve, and a second heat exchanger that are sequentially connected. The first heat exchanger includes a first refrigerant path and a first coolant path, the first refrigerant path is connected between the first compressor and the first expansion valve, and the first refrigerant path is configured to exchange heat with the first coolant path. A liquid outlet of the first coolant path is configured to connect to a liquid injection port of an electric vehicle and a liquid inlet of a liquid cooling channel of a charger, and a liquid inlet of the first coolant path is configured to connect to a liquid return port of the electric vehicle.

In the liquid cooling device provided in embodiments of this application, the liquid inlet of the first coolant path of the first heat exchanger is connected to the liquid injection port of the electric vehicle, and the liquid outlet of the first coolant path is connected to the liquid return port of the electric vehicle, so that a coolant circulation loop can be formed between the first coolant path and the electric vehicle. In this way, coolant circulates between the first coolant path and the electric vehicle, so that the liquid cooling device can dissipate heat for a power battery of the electric vehicle. In addition, the liquid inlet of the first coolant path is connected to the liquid inlet of the liquid cooling channel of the charger, so that the first coolant path may further provide the coolant for the liquid cooling channel of the charger. In this way, the liquid cooling channel of the charger dissipates heat for a charging cable of the charger by using the coolant provided by the liquid cooling device.

Therefore, the liquid cooling device may be configured to dissipate heat for both the power battery of the electric vehicle and the charging cable of the charger. This can meet heat dissipation requirements of both the charger and the electric vehicle during high-power charging, and improve efficiency and safety of charging the electric vehicle by the charger. In addition, because the electric vehicle and the charger share the liquid cooling device for heat dissipation, the liquid cooling device can have high utilization, to facilitate cost optimization of the liquid cooling device.

In an embodiment of this application, the liquid cooling device further includes a liquid storage tank, and the liquid outlet of the first coolant path is configured to connect to the liquid injection port of the electric vehicle and the liquid inlet of the liquid cooling channel of the charger through the liquid storage tank. A first liquid inlet of the liquid storage tank is connected to the liquid outlet of the first coolant path, a first liquid outlet of the liquid storage tank is configured to connect to the liquid injection port of the electric vehicle, and a second liquid outlet of the liquid storage tank is configured to connect to the liquid inlet of the liquid cooling channel of the charger.

Based on the foregoing design, the coolant in the first coolant path of the first heat exchanger may flow into the liquid storage tank in advance for storage after exchanging heat with the first refrigerant path for cooling. When the electric vehicle and/or the charging cable of the charger needs to dissipate heat, coolant with a low temperature stored in the liquid storage tank may quickly flow into the electric vehicle and/or the liquid cooling channel of the charger. This can improve timeliness of heat dissipation performed by the liquid cooling device on the power battery of the electric vehicle and the charging cable of the charger, to further improve efficiency of charging the electric vehicle by the charger.

In an embodiment of this application, the liquid inlet of the first coolant path is configured to connect to a liquid outlet of the liquid cooling channel of the charger, or a second liquid inlet of the liquid storage tank is configured to connect to the liquid outlet of the liquid cooling channel of the charger.

Based on the foregoing design, the coolant in the liquid cooling channel of the charger may flow back to the first coolant channel of the first heat exchanger for cooling, and then flow into the liquid storage tank. In this way, the coolant in the liquid storage tank can maintain a low temperature, thereby helping improve a cooling storage capability of the liquid storage tank. Alternatively, the coolant in the liquid cooling channel of the charger may directly flow back to the liquid storage tank, so that a coolant circulation loop is separately formed between the liquid cooling channel of the charger and the liquid storage tank. In other words, the liquid storage tank serves as both a water supply tank and a water return tank of the charger. This can reduce a circulation path of the coolant between the liquid cooling device and the liquid cooling channel of the charger, to help improve efficiency of dissipating heat for the charging cable of the charger by the liquid cooling device.

In an embodiment of this application, a third liquid outlet of the liquid storage tank is connected to the liquid inlet of the first coolant path.

Based on the foregoing design, a coolant circulation loop may be formed between the liquid storage tank and the first coolant path of the first heat exchanger. In this way, during actual application, the first heat exchanger may dissipate heat for the coolant in the liquid storage tank, so that the coolant in the liquid storage tank maintains a low temperature, to improve a cooling storage capability of the liquid storage tank. This helps improve timeliness and effect of heat dissipation performed by the liquid cooling device on the power battery of the electric vehicle and the charging cable of the charger.

In an embodiment of this application, the liquid cooling device further includes a three-way valve, a first valve port of the three-way valve is configured to connect to the liquid return port of the electric vehicle, a second valve port of the three-way valve is connected to the third liquid outlet of the liquid storage tank, and a third valve port of the three-way valve is connected to the liquid inlet of the first coolant path.

Based on the foregoing design, a flow channel of the coolant may be switched by adjusting on/off states of different valve ports of the three-way valve, so that the first refrigerant path exchanges heat with the coolant flowing out of the electric vehicle, or the first refrigerant path exchanges heat with the coolant flowing out of the liquid storage tank.

In an embodiment of this application, the three-way valve is configured to: when no coolant is output from the first liquid outlet of the liquid storage tank and the second liquid outlet of the liquid storage tank, connect a path between the liquid inlet of the first coolant path and the third liquid outlet of the liquid storage tank, and disconnect a path between the liquid inlet of the first coolant path and the liquid return port of the electric vehicle.

In the foregoing technical solution, when the charger does not charge the electric vehicle, the first liquid outlet of the liquid storage tank and the second liquid outlet of the liquid storage tank may not provide the coolant for the electric vehicle and the liquid cooling channel of the charger. In this case, the on/off state of the different valve ports of the three-way valve may be adjusted, so that the first refrigerant path of the first heat exchanger exchanges heat with the coolant flowing out of the liquid storage tank. In this way, the coolant in the liquid storage tank can maintain a low temperature, thereby improving a cooling storage capability of the liquid storage tank. In this way, when the charger charges the electric vehicle, the coolant with the low temperature stored in the liquid storage tank may quickly flow into the electric vehicle and the liquid cooling channel of the charger. This can improve timeliness and effect of heat dissipation performed by the liquid cooling device on the power battery of the electric vehicle and the charging cable of the charger.

In an embodiment of this application, the three-way valve is configured to: when the coolant is output from the first liquid outlet of the liquid storage tank, connect the path between the liquid inlet of the first coolant path and the liquid return port of the electric vehicle, and disconnect the path between the liquid inlet of the first coolant path and the third liquid outlet of the liquid storage tank.

In the foregoing technical solution, when the charger charges the electric vehicle, the first liquid outlet of the liquid storage tank provides the coolant for the electric vehicle. In this case, the on/off state of the different valve ports of the three-way valve may be adjusted, so that the first refrigerant path of the first heat exchanger exchanges heat with only the coolant flowing out of the electric vehicle. This helps improve efficiency of heat dissipation performed by the liquid cooling device on the power battery of the electric vehicle.

In an embodiment of this application, the liquid storage tank includes a tank body, the tank body includes two chambers that communicate with each other, and one of the chambers is located below the other chamber in a gravity direction. The first liquid inlet of the liquid storage tank, the first liquid outlet of the liquid storage tank, and the second liquid outlet of the liquid storage tank are located in the tank body corresponding to the one chamber, and the third liquid outlet of the liquid storage tank is located in the tank body corresponding to the other chamber.

In the foregoing technical solution, a liquid inlet and a liquid outlet for flowing high-temperature coolant in the liquid storage tank are disposed above a liquid inlet and a liquid outlet for flowing low-temperature coolant, so that mixed convection of the high-temperature coolant and the low-temperature coolant in the liquid storage tank can be reduced, to reduce impact of the high-temperature coolant on the low-temperature coolant, and improve heat dissipation efficiency of the liquid cooling device.

In an embodiment of this application, the liquid inlet of the first coolant path is configured to connect to the liquid return port of the electric vehicle through the liquid storage tank. A third liquid inlet of the liquid storage tank is configured to connect to the liquid return port of the electric vehicle, and a fourth liquid outlet of the liquid storage tank is connected to the liquid inlet of the first coolant path.

Based on the foregoing design, the liquid storage tank not only serves as a water supply tank for both the charger and the electric vehicle, but also serves as a water return tank for both the charger and the electric vehicle. This can keep a capacity of the coolant in the liquid storage tank in a stable state, thereby stabilizing a pressure inside the liquid storage tank.

In an embodiment of this application, the liquid storage tank includes two chambers, and the two chambers do not communicate with each other. The first liquid inlet of the liquid storage tank, the first liquid outlet of the liquid storage tank, the second liquid outlet of the liquid storage tank, and the third liquid outlet of the liquid storage tank communicate with one of the chambers, and the third liquid inlet of the liquid storage tank and the fourth liquid outlet of the liquid storage tank communicate with the other chamber.

Based on the foregoing design, low-temperature coolant that is in the liquid cooling device and that is output to the electric vehicle and the charger can flow in one chamber of the liquid storage tank, and high-temperature coolant that flows back from the electric vehicle and the charger to the liquid storage tank can flow in the other chamber of the liquid storage tank. This can avoid mixing of the high-temperature coolant and the low-temperature coolant in the liquid storage tank, and help the liquid storage tank stably output the low-temperature coolant to the electric vehicle and the liquid cooling channel of the charger, to ensure that the liquid cooling device can dissipate heat for the power battery of the electric vehicle and the charging cable of the charger.

In an embodiment of this application, the liquid cooling device further includes a liquid storage tank, and the liquid inlet of the first coolant path is configured to connect to the liquid return port of the electric vehicle and a liquid outlet of the liquid cooling channel of the charger through the liquid storage tank. A first liquid outlet of the liquid storage tank is connected to the liquid inlet of the first coolant path, a first liquid inlet of the liquid storage tank is configured to connect to the liquid return port of the electric vehicle, and a second liquid inlet of the liquid storage tank is configured to connect to the liquid outlet of the liquid cooling channel of the charger.

Based on the foregoing design, the liquid storage tank is configured to store the coolant in the liquid cooling device. When the power battery of the electric vehicle and/or the charging cable of the charger need to dissipate heat, the coolant in the liquid storage tank may quickly flow into the liquid cooling channel of the electric vehicle and/or the charger after being cooled in the first coolant path of the first heat exchanger, so that the liquid cooling device dissipates heat for the power battery of the electric vehicle and the charging cable of the charger.

In an embodiment of this application, the liquid cooling device further includes a solenoid valve, a first valve port of the solenoid valve is connected to the liquid outlet of the first coolant path, and a second valve port of the solenoid valve is connected to a third liquid inlet of the liquid storage tank.

Based on the foregoing design, a coolant circulation loop may be formed between the liquid storage tank and the first coolant path through the solenoid valve. In this way, the coolant circulates between the liquid storage tank and the first coolant path, so that the first coolant path can dissipate heat for the coolant in the liquid storage tank, and the coolant in the liquid storage tank maintains a low temperature, to improve a cooling storage capability of the liquid storage tank. In addition, during actual application, the circulation loop between the liquid storage tank and the first coolant path may be connected or disconnected by adjusting an on/off state of the solenoid valve.

In an embodiment of this application, the liquid cooling device is configured to: when no coolant is received through the first liquid inlet of the liquid storage tank and the second liquid inlet of the liquid storage tank, control the solenoid valve to be turned on; or when coolant is received through a liquid inlet in the first liquid inlet of the liquid storage tank and the second liquid inlet of the liquid storage tank, control the solenoid valve to be turned off.

Based on the foregoing design, when the charger does not charge the electric vehicle, the coolant from the electric vehicle and the liquid cooling channel of the charger may not be received through the first liquid inlet of the liquid storage tank and the second liquid inlet of the liquid storage tank. In this case, the solenoid valve may be turned on, to connect a circulation loop between the liquid storage tank and the first coolant path, so that the first heat exchanger cools the coolant in the liquid storage tank. In this way, the coolant in the liquid storage tank can maintain a low temperature, thereby improving a cooling storage capability of the liquid storage tank. When the charger charges the electric vehicle, the coolant is received through a liquid inlet in the first liquid inlet of the liquid storage tank and the second liquid inlet of the liquid storage tank. In this case, the circulation loop between the first coolant path and the liquid storage tank may be disconnected by turning off the solenoid valve. In this way, the coolant flowing out of the first coolant path can flow only into the electric vehicle and/or the liquid cooling channel of the charger, thereby helping improve efficiency of heat dissipation performed by the liquid cooling device on the power battery of the electric vehicle and the charging cable of the charger.

In an embodiment of this application, the liquid storage tank includes a tank body, the tank body includes two chambers that communicate with each other, and one of the chambers is located below the other chamber in a gravity direction. The third liquid inlet of the liquid storage tank is located in the tank body corresponding to the one chamber, and the first liquid outlet of the liquid storage tank, the first liquid inlet of the liquid storage tank, and the second liquid inlet of the liquid storage tank are located in the tank body corresponding to the other chamber.

In the foregoing technical solution, a liquid inlet and a liquid outlet for flowing high-temperature coolant in the liquid storage tank are disposed above a liquid inlet and a liquid outlet for flowing low-temperature coolant, so that mixed convection of the high-temperature coolant and the low-temperature coolant in the liquid storage tank can be reduced, to reduce impact of the high-temperature coolant on the low-temperature coolant, and improve heat dissipation efficiency of the liquid cooling device.

In an embodiment of this application, the liquid cooling device further includes a bypass valve. A first valve port of the bypass valve is connected to the liquid outlet of the first coolant path, and a second valve port of the bypass valve is connected to a fourth liquid inlet of the liquid storage tank. The bypass valve is configured to: when a pressure of the coolant flowing out of the liquid outlet of the first coolant path is greater than a preset pressure, connect a path between the liquid outlet of the first coolant path and the fourth liquid inlet of the liquid storage tank.

Based on the foregoing design, the bypass valve may release the pressure of the coolant flowing out of the first coolant path, so that the pressure of the coolant distributed by the first coolant path to the electric vehicle and the charger remains in a stable state, to improve reliability of heat dissipation performed by the liquid cooling device on the power battery of the electric vehicle and the charging cable of the charger.

In an embodiment of this application, the liquid cooling device further includes at least one of a first filter and a second filter. The first filter is configured to be connected between the liquid outlet of the first coolant path and the liquid injection port of the electric vehicle; and the second filter is configured to be connected between the liquid inlet of the first coolant path and the liquid return port of the electric vehicle.

Based on the foregoing design, the first filter may filter out impurities in the coolant transferred from the liquid cooling device to the electric vehicle, to control cleanliness of the coolant that flows from the liquid cooling device to the electric vehicle. In addition, the second filter may filter out impurities in the coolant transferred from the electric vehicle to the liquid cooling device, to control cleanness of the coolant that flows from the electric vehicle to the liquid cooling device.

In an embodiment of this application, the liquid cooling device further includes a second compressor, a second expansion valve, and a third heat exchanger. The second compressor, the first heat exchanger, the second expansion valve, and the third heat exchanger are sequentially connected, the first heat exchanger further includes a second refrigerant path, the second refrigerant path is connected between the second compressor and the second expansion valve, and the second refrigerant path is configured to exchange heat with the first coolant path.

Based on the foregoing design, both the two refrigerant paths in the first heat exchanger can be configured to exchange heat with the first coolant path, to improve heat dissipation efficiency of the coolant in the first coolant path. This can improve efficiency of heat dissipation performed by the liquid cooling device on the power battery of the electric vehicle and the charging cable of the charger.

In an embodiment of this application, the liquid cooling device further includes a liquid cooling connector. The liquid cooling connector includes a liquid outlet connector and a liquid inlet connector, the liquid outlet connector is configured to connect to the liquid injection port of the electric vehicle, and the liquid inlet connector is configured to connect to the liquid return port of the electric vehicle. The liquid outlet connector is configured to transfer the coolant output by the liquid cooling device to the liquid injection port of the electric vehicle, and the liquid inlet connector is configured to transfer the coolant output from the liquid return port of the electric vehicle to the liquid cooling device.

Based on the foregoing design, the liquid cooling device may form a coolant circulation loop with the electric vehicle via the liquid cooling connector that is separately disposed, so that during actual application, electric energy and the coolant may be provided for the electric vehicle via the charger and the liquid cooling connector, respectively. Compared with a manner in which a coolant pipeline connected to the liquid cooling device is additionally disposed in the charger to provide both electric energy and coolant for the electric vehicle via the charger, the foregoing manner can implement mutual isolation between transmitting the electric energy and transmitting the coolant to the electric vehicle, to improve reliability of charging and heat dissipation performed by the charger and the liquid cooling connector on the power battery of the electric vehicle.

In addition, additionally disposing the coolant pipeline connected to the liquid cooling device in the charger is likely to cause an increase in an overall weight of the charger. Therefore, in embodiments of this application, the coolant is provided for the electric vehicle via the liquid cooling connector that is separately disposed, so that the weight increase of the charger caused by additionally disposing the coolant pipeline can be avoided, thereby facilitating a connector plugging operation of a user and improving user experience.

According to a second aspect, a charging pile is provided. The charging pile includes a plurality of charging modules, a charger, and the liquid cooling device according to any one of the designs of the first aspect. The charger is configured to transfer electric energy output by the plurality of charging modules to an electric vehicle, and a liquid inlet of a liquid cooling channel of the charger is configured to receive coolant output by the liquid cooling device.

In some embodiments of this application, the charging pile further includes a switch and a fourth heat exchanger, and output ends of the plurality of charging modules are connected to the charger through the switch. The fourth heat exchanger includes a first gas path and a second coolant path, and the second coolant path is configured to exchange heat with the first gas path. An inlet of the first gas path and an outlet of the first gas path communicate with an environment in which the switch is located. A liquid inlet of the second coolant path is configured to receive the coolant output by the liquid cooling device.

Based on the foregoing design, gas in the environment in which the switch is located may flow in the first gas path, and the second coolant path may cool the gas flowing in the first gas path by using the coolant provided by the liquid cooling device, to absorb heat of the switch by using the gas after cooling, thereby implementing heat dissipation of the switch by the liquid cooling device. This can further improve utilization of the liquid cooling device, thereby facilitating cost optimization of the charging pile.

For beneficial effect that is not described in detail in the second aspect, refer to the beneficial effect in the first aspect. Details are not described herein again.

### BRIEF DESCRIPTION OF DRAWINGS

FIG. 1 is a diagram of a structure of a charging system according to an embodiment of this application;
FIG. 2 is a diagram of an application scenario of a charging pile according to an embodiment of this application;
FIG. 3 is a diagram of a structure of a charging pile according to an embodiment of this application;
FIG. 4 is a diagram of a structure of a liquid cooling device according to an embodiment of this application;
FIG. 5 and FIG. 6 are respectively diagrams of specific structures of an example of the liquid cooling device shown in FIG. 4;
FIG. 7 is a diagram of a specific structure of an example of a liquid storage tank in the liquid cooling device shown in FIG. 6;
FIG. 8 is a diagram of a specific structure of another example of the liquid cooling device shown in FIG. 4;
FIG. 9 is a diagram of a specific structure of an example of a liquid storage tank in the liquid cooling device shown in FIG. 8;
FIG. 10 is a diagram of a specific structure of still another example of the liquid cooling device shown in FIG. 4;
FIG. 11 is a diagram of a specific structure of an example of a liquid storage tank in the liquid cooling device shown in FIG. 10; and
FIG. 12 is a diagram of a structure of another liquid cooling device according to an embodiment of this application.

### DESCRIPTION OF EMBODIMENTS

For ease of understanding embodiments of this application, the following descriptions are provided before embodiments of this application are described.

In the descriptions of embodiments of this application, a connection may be an electrical connection, or may be a pipeline connection. The electrical connection may be understood as that signal transmission is implemented between two electrical elements in a direct electrical connection manner or an indirect electrical connection manner. For example, that A is electrically connected to B may be understood as that A is directly electrically connected to B, or may be understood as that A is indirectly electrically connected to B via one or more other electrical elements.

In embodiments of this application, the terms "first" and "second" are merely intended for a purpose of description, and shall not be understood as an indication or implication of relative importance or an implicit indication of a quantity of indicated technical features. Therefore, a feature limited by "first" or "second" may explicitly or implicitly include one or more features. In addition, in the descriptions of embodiments of this application, "a plurality of" means two or more, and "at least one" and "one or more" mean one, two, or more.

In the descriptions of embodiments of this application, unless otherwise specified, "and/or" describes only an association relationship between associated objects and indicates that three relationships may exist. For example, A and/or B may indicate the following three cases: Only A exists, both A and B exist, and only B exists.

The following describes technical solutions of this application with reference to the accompanying drawings.

To facilitate understanding of technical solutions provided in embodiments of this application, an application scenario to which embodiments of this application are applicable is first described.

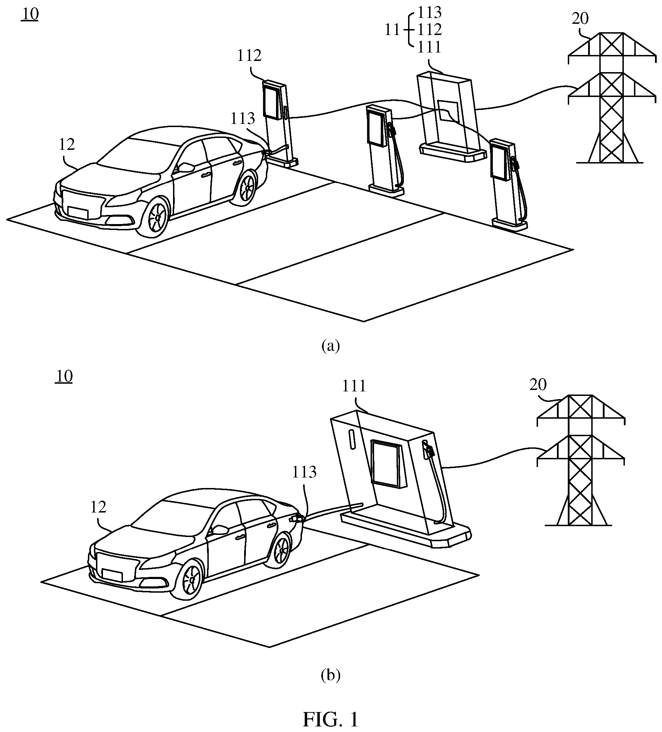

FIG. 1 is a diagram of a structure of a charging system 10 according to an embodiment of this application.

As shown in (a) and (b) in FIG. 1, the charging system 10 includes a charging device 11 and an electric vehicle 12. The charging device 11 is configured to: receive an alternating current output by a power grid 20, convert the alternating current into a stable direct current, and transmit the stable direct current to the electric vehicle 12, to charge the electric vehicle 12. Alternatively, in some other embodiments, the electric vehicle 12 may reversely output electric energy to the power grid 20 via the charging device 11.

In some embodiments, as shown in (a) in FIG. 1, the charging device 11 is a split charging device. Specifically, the charging device 11 includes a power unit 111, at least one charging terminal 112, and at least one charger 113. The power unit 111 includes a plurality of charging modules (not shown in the figure), and output ends of the plurality of charging modules are connected to the at least one charging terminal 112. The plurality of charging modules are configured to convert the alternating current output by the power grid 20 into a stable direct current, and then output the stable direct current to the connected charging terminal 112.

It should be understood that, in embodiments of this application, the plurality of charging modules include, for example, an alternating current-direct current (alternating current-direct current, AC-DC) conversion apparatus and a direct current-direct current (direct current-direct current, DC-DC) conversion apparatus.

In addition, the at least one charging terminal 112 is connected to the at least one charger 113, and each charger 113 is configured to connect to the electric vehicle 12. In this way, the charging terminal 112 may transmit, to the electric vehicle 12 via the charger 113, the direct current output by the plurality of charging modules. During specific implementation, one charging terminal 112 may be connected to one or more chargers 113, and the one or more chargers 113 may be connected to the same electric vehicle 12.

It should be understood that, in embodiments of this application, the charging terminal 112 includes a housing, and a human-computer interaction interface, a charging control unit, a measurement and billing unit, and the like that are disposed in the housing, so that the charging terminal 112 may be configured to perform information exchange, energy transmission, measurement and billing, and the like with the electric vehicle 12.

For example, the charger 113 includes a charging cable and a charger head. One end of the charging cable is connected to the output ends of the plurality of charging modules, the other end of the charging cable is connected to the charger head, and the charger head is configured to connect to a charging port of the electric vehicle 12. In this way, the direct current output by the plurality of charging modules is transmitted to the electric vehicle 12 via the charger 113.

In embodiments of this application, the electric vehicle 12 is a vehicle driven by electric energy. The electric vehicle 12 is a pure electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), or the like.

In some other embodiments, as shown in (b) in FIG. 1, the charging device 11 is an integrated charging device. Specifically, the human-computer interaction interface, the charging control unit, the measurement and billing unit, and the like in the charging terminal 112 and the plurality of charging modules may be disposed in the power unit 111 together, for example, disposed in a case of the power unit 111 together. In addition, the charger 113 is also directly connected to the power unit 111. In this way, the charging device 11 may include only the power unit 111 and the at least one charger 113 connected to the power unit 111, and does not include the charging terminal 112.

As described in the background, as the charging device 11 continuously evolves to an ultra-fast charging device, charging power output by the plurality of charging modules to the electric vehicle 12 via the charger 113 continuously increases, to implement high-power charging such as ultra-fast charging on a power battery of the electric vehicle 12. However, as the charging power continuously increases, not only heat generated by the charging cable of the charger 113 increases, but also heat generated by the power battery of the electric vehicle 12 greatly increases. If the heat cannot be discharged in a timely manner, a temperature of the charger 113 and a temperature of the power battery increase together. However, an excessively high temperature is likely to affect normal high-power charging on the electric vehicle 12 by the charging device 11, and consequently, efficiency and safety of charging the electric vehicle 12 by the charging device 11 decrease.

The electric vehicle 12 usually has a thermal management system, and the thermal management system may provide a required cooling capacity for heat dissipation of the power battery. However, in addition to providing the cooling capacity for the power battery, the thermal management system further needs to provide a required cooling capacity for a motor, a passenger compartment, an air conditioner, and the like in the electric vehicle 12. Therefore, during actual application, the thermal management system can provide a limited cooling capacity for the power battery, and heat dissipation of the power battery by only the thermal management system cannot meet an increasing heat dissipation requirement of the power battery during high-power charging.

Therefore, a heat dissipation problem of the charging cable and the power battery becomes a key problem in implementing high-power charging of the electric vehicle 12.

Based on the foregoing content, embodiments of this application provide a liquid cooling device and a charging pile including the liquid cooling device. The liquid cooling device may separately provide coolant for a liquid cooling channel of a charger and an electric vehicle, to dissipate heat for a charging cable of the charger and a power battery of the electric vehicle. In this way, heat dissipation requirements of both the charger and the power battery during high-power charging can be met, efficiency and safety of charging the electric vehicle by the charging pile are improved, and the liquid cooling device can have high utilization.

The following describes the charging pile provided in embodiments of this application with reference to the accompanying drawings.

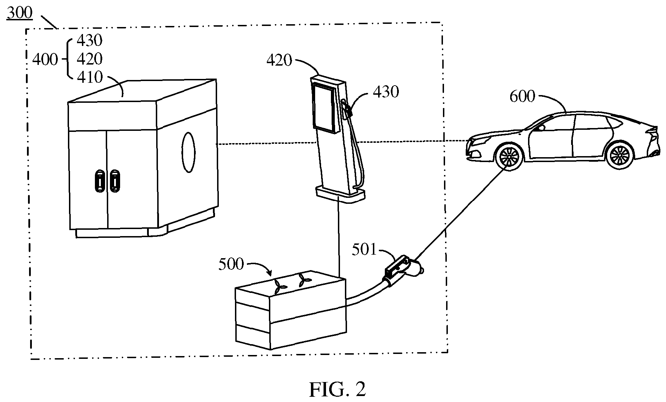

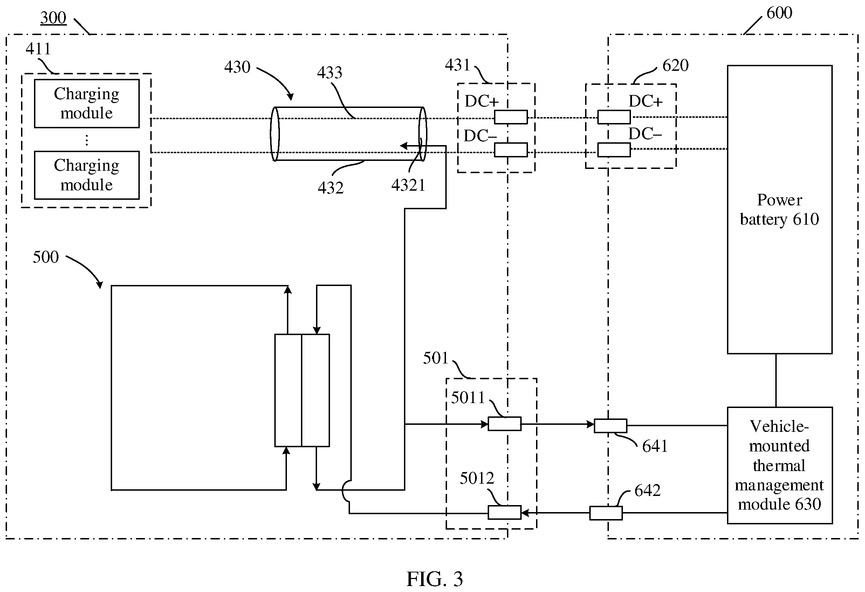

FIG. 2 is a diagram of an application scenario of a charging pile 300 according to an embodiment of this application. FIG. 3 is a diagram of a structure of the charging pile 300 shown in FIG. 2. It should be noted that, for ease of understanding, in FIG. 2 and FIG. 3, a dashed line indicates a power transmission line, and a solid line indicates a pipeline connection line used for circulation of coolant, a refrigerant, or the like.

With reference to FIG. 2 and FIG. 3, the charging pile 300 includes a plurality of charging modules 411, a charger 430, and a liquid cooling device 500.

The charger 430 is configured to transmit, to an electric vehicle 600, electric energy output by the plurality of charging modules 411.

Specifically, as shown in FIG. 3, the charger 430 includes a charging connector 431 and a liquid cooling cable, and the liquid cooling cable includes a liquid cooling channel 432 and a charging cable 433. The charging cable 433 is connected between the charging connector 431 and output ends of the plurality of charging modules 411, to transmit, to the charging connector 431, the electric energy output by the plurality of charging modules 411. The liquid cooling channel 432 is configured to allow circulation of the coolant, to perform liquid cooling and heat dissipation on the charging cable 433.

Correspondingly, the electric vehicle 600 includes a power battery 610 and a charging port 620 connected to the power battery 610. The charging port 620 is configured to be in plugged connection to the charging connector 431, to transmit, to the power battery 610, electric energy output by the plurality of charging modules 411, so that the electric vehicle 600 is charged via the plurality of charging modules 411.

It should be understood that during specific implementation, as shown in FIG. 2, the charging pile 300 further includes a charging device 400, and the plurality of charging modules 411 and the charger 430 are disposed in the charging device 400. The charging device 400 may be, for example, the split charging device shown in (a) in FIG. 1. To be specific, the charging device 400 includes a power unit 410 and a charging terminal 420. The plurality of charging modules 411 are disposed in the power unit 410. The charger 430 is connected to the charging terminal 420, and is connected to output ends of the plurality of charging modules 411 via the charging terminal 420. Alternatively, the charging device 400 may be the integrated charging device shown in (b) in FIG. 1. To be specific, the charging device 400 includes a power unit 410, and does not include a charging terminal 420. The plurality of charging modules 411 are disposed in the power unit 410, and the charger 430 is also directly connected to the power unit 410.

For specific descriptions of the charging device 400, refer to related descriptions of the embodiment shown in FIG. 1. Details are not described herein again.

It should be further understood that, in embodiments of this application, the charging connector 431 includes a positive direct current plug DC+ and a negative direct current plug DC-, and the charging cable 433 includes a positive charging cable and a negative charging cable. The positive charging cable is connected between the output ends of the plurality of charging modules 411 and the positive direct current plug DC+, and the negative charging cable is connected between the output ends of the plurality of charging modules 411 and the negative direct current plug DC-.

For example, the positive charging cable and the negative charging cable are located outside the liquid cooling channel 432 and are connected to an outer wall of the liquid cooling channel 432 in a thermally conductive manner. Alternatively, the positive charging cable and the negative charging cable are located inside the liquid cooling channel 432 and are immersed in the coolant flowing in the liquid cooling channel 432.

It should be understood that specific structures of the liquid cooling channel 432 and the charging cable 433 in the liquid cooling cable are merely examples. In embodiments of this application, the specific structure of the liquid cooling cable can enable the liquid cooling channel 432 to perform liquid cooling and heat dissipation on the charging cable 433.

Still with reference to FIG. 2 and FIG. 3, a liquid outlet of the liquid cooling device 500 is configured to connect to a liquid injection port 641 of the electric vehicle, and a liquid inlet of the liquid cooling device 500 is configured to connect to a liquid return port 642 of the electric vehicle 600, so that the liquid cooling device 500 can dissipate heat for the power battery 610 through circulation of the coolant between the liquid cooling device 500 and the electric vehicle 600.

In an example, the charger 430 further includes a liquid outlet connector and a liquid inlet connector. The liquid outlet connector is configured to connect to the liquid injection port 641 of the electric vehicle, and the liquid inlet connector is configured to connect to the liquid return port 642 of the electric vehicle. The liquid outlet connector is configured to transfer the coolant output by the liquid cooling device 500 to the liquid injection port 641 of the electric vehicle, and the liquid inlet connector is configured to transfer the coolant output from the liquid return port 642 of the electric vehicle to the liquid cooling device 500. In other words, the charger 430 is a liquid cooling and charging composite connector.

During specific implementation, as shown in FIG. 2, the liquid cooling device 500 may be separately disposed outside the charging device 400. The liquid outlet of the liquid cooling device 500 and the liquid inlet of the liquid cooling device 500 are respectively correspondingly connected to the liquid outlet connector and the liquid inlet connector of the charger 430 through pipelines. Alternatively, the liquid cooling device 500 may be disposed inside the charging device 400, for example, disposed inside a housing of the charging terminal 420. The liquid outlet of the liquid cooling device 500 and the liquid inlet of the liquid cooling device 500 may also be correspondingly connected to the liquid outlet connector and the liquid inlet connector of the charger 430 through pipelines.

Therefore, when the charger 430 is connected to the electric vehicle 600, the coolant in the liquid cooling device 500 may flow into the electric vehicle 600 through the liquid outlet connector of the charger 430 and the liquid injection port 641 of the electric vehicle, and the coolant in the electric vehicle 600 may flow into the liquid cooling device 500 through the liquid return port 642 of the electric vehicle and the liquid inlet connector of the charger 430, so that the liquid cooling device 500 dissipates heat for the power battery 610.

In another example, as shown in FIG. 2 and FIG. 3, the liquid cooling device 500 includes a liquid cooling connector 501. The liquid cooling connector 501 includes a liquid outlet connector 5011 and a liquid inlet connector 5012. The liquid outlet connector 5011 is configured to connect to the liquid injection port 641 of the electric vehicle, and the liquid inlet connector 5012 is configured to connect to the liquid return port 642 of the electric vehicle. The liquid outlet connector 5011 is configured to transfer the coolant output by the liquid cooling device 500 to the liquid injection port 641 of the electric vehicle, and the liquid inlet connector 5012 is configured to transfer the coolant output from the liquid return port 642 of the electric vehicle to the liquid cooling device 500.

During specific implementation, as shown in FIG. 2, when the liquid cooling device 500 is separately disposed outside the charging device 400, the liquid cooling connector 501 and the liquid cooling device 500 may be located outside the charging device 400 together. The liquid outlet connector 5011 of the liquid cooling connector 501 is connected to the liquid outlet of the liquid cooling device 500 through a pipeline, and the liquid inlet connector 5012 is connected to the liquid inlet of the liquid cooling device 500 through a pipeline. Alternatively, when the liquid cooling device 500 is disposed inside the charging device 400, for example, when the liquid cooling device 500 is disposed inside the housing of the charging terminal 420, the liquid cooling connector 501 and the charger 430 may be connected to the charging terminal 420 together. The liquid outlet connector 5011 of the liquid cooling connector 501 is connected to the liquid outlet of the liquid cooling device 500 in the charging terminal 420 through a pipeline, and the liquid inlet connector 5012 is connected to the liquid inlet of the liquid cooling device 500 in the charging terminal 420 through a pipeline.

Therefore, when the liquid cooling connector 501 is connected to the electric vehicle 600, the coolant in the liquid cooling device 500 may flow into the electric vehicle 600 through the liquid outlet connector 5011 of the liquid cooling connector 501 and the liquid injection port 641 of the electric vehicle, and the coolant in the electric vehicle 600 may flow into the liquid cooling device 500 through the liquid return port 642 of the electric vehicle and the liquid inlet connector 5012 of the liquid cooling connector 501, so that the liquid cooling device 500 dissipates heat for the power battery 610.

In the foregoing technical solution, the charging pile 300 may provide electric energy and the coolant for the electric vehicle 600 via the charger 430 and the liquid cooling connector 501, respectively. Compared with a manner in which a coolant pipeline connected to the liquid cooling device 500 is additionally disposed in the charger 430 to provide both electric energy and coolant for the electric vehicle 600 via the charger 430, the foregoing manner can implement mutual isolation between transmitting the electric energy and transmitting the coolant to the electric vehicle 600, to improve reliability of charging and heat dissipation performed by the charger 430 and the liquid cooling connector 501 on the power battery 610.

In addition, additionally disposing the coolant pipeline connected to the liquid cooling device 500 in the charger 430 is likely to cause an increase in an overall weight of the charger 430. Therefore, in embodiments of this application, the coolant is provided for the electric vehicle 600 via the liquid cooling connector 501 that is separately disposed, so that the weight increase of the charger 430 caused by additionally disposing the coolant pipeline can be avoided, thereby facilitating a connector plugging operation of a user and improving user experience.

It should be noted that, for ease of description and understanding, embodiments of this application are described by using an example in which the liquid cooling device 500 is connected to the electric vehicle 600 via the liquid cooling connector 501, and both the liquid cooling device 500 and the liquid cooling connector 501 are disposed outside the charging device 400.

Still refer to FIG. 3. In some embodiments, the electric vehicle 600 further includes a vehicle-mounted thermal management module 630. The vehicle-mounted thermal management module 630 is configured to perform temperature management on the power battery 610. A liquid inlet of the vehicle-mounted thermal management module 630 is connected to the liquid injection port 641 of the electric vehicle, and a liquid outlet of the vehicle-mounted thermal management module 630 is connected to the liquid return port 642 of the electric vehicle. In this way, the coolant in the liquid cooling device 500 may circulate between the liquid cooling device 500 and the vehicle-mounted thermal management module 630 through the liquid injection port 641 of the electric vehicle and the liquid return port 642 of the electric vehicle, so that the liquid cooling device 500 dissipates heat for the power battery 610.

For example, the vehicle-mounted thermal management module 630 includes a power battery heat exchanger and a vehicle-mounted thermal management system, and the power battery heat exchanger may be, for example, a liquid cooling plate having a coolant runner. The power battery heat exchanger is configured to be in contact with the power battery 610 in a thermally conductive manner, and the power battery heat exchanger is connected to the vehicle-mounted thermal management system through a pipeline, to dissipate heat for the power battery 610 through circulation of the coolant between the power battery heat exchanger and the vehicle-mounted thermal management system. In addition, a liquid inlet of the vehicle-mounted thermal management system is connected to the liquid injection port 641 of the electric vehicle, and a liquid outlet of the vehicle-mounted thermal management system is connected to the liquid return port 642 of the electric vehicle, to cyclically dissipate heat for the power battery 610 through circulation of the coolant between the vehicle-mounted thermal management system and the liquid cooling device 500.

It should be understood that a specific structure of the vehicle-mounted thermal management module 630 is merely an example. In embodiments of this application, the vehicle-mounted thermal management module 630 can be configured to allow circulation of the coolant to dissipate heat for the power battery 610.

It should be further understood that, in embodiments of this application, the coolant in the liquid cooling device 500 and the coolant in the electric vehicle 600 may be of the same type, for example, may be antifreeze of different specifications, for example, antifreeze of -35°C (namely, a glycol solution with 50% concentration). This helps reduce risks of coolant deterioration and coolant pipeline blockage caused by different types of coolant in the liquid cooling device 500 and the electric vehicle 600.

In the charging pile 300 provided in embodiments of this application, the liquid cooling device 500 and the vehicle-mounted thermal management module 630 of the electric vehicle 600 may form a coolant circulation loop. In this way, the liquid cooling device 500 can dissipate heat for the power battery 610 through circulation of the coolant between the liquid cooling device 500 and the vehicle-mounted thermal management module 630. This can meet a heat dissipation requirement of the power battery 610 during high-power ultra-fast charging, and help improve efficiency and safety of charging the power battery 610 by the charging pile 30, to ensure normal high-power charging of the power battery 610.

In addition, in some solutions, the heat dissipation requirement of the power battery 610 during high-power charging is met by enhancing a cooling capability of the vehicle-mounted thermal management module 630 and increasing a refrigerating capacity of the vehicle-mounted thermal management module 630. However, this needs to rectify a vehicle cooling system of the electric vehicle 600. Consequently, a weight and a size of the vehicle are increased, and energy consumption of the vehicle is also greatly increased. In addition, when the electric vehicle 600 performs low-power fast charging, a rectified part of the vehicle cooling system is in an idle state, and therefore, utilization of the cooling system is low.

Therefore, in embodiments of this application, the liquid cooling device 500 in the charging pile 300 dissipates heat for the power battery 610, so that the heat dissipation requirement of the power battery 610 during high-power ultra-fast charging can be met, and a large-scale rectification on the vehicle cooling system can be avoided, thereby avoiding increases in the weight and the size of the entire vehicle, and facilitating cost optimization of the electric vehicle 600.

Still with reference to FIG. 2 and FIG. 3, the liquid outlet of the liquid cooling device 500 is further connected to a liquid inlet of the liquid cooling channel of the charger 430. The liquid inlet of the liquid cooling channel of the charger 430 is a liquid inlet 4321 of the liquid cooling channel 432 in the liquid cooling cable.

Based on the foregoing design, the liquid cooling channel 432 may absorb, by using the coolant provided by the liquid cooling device 500, heat generated by the charging cable 433, so that the liquid cooling device 500 dissipates heat for the charging cable 433.

In the charging pile 300 provided in embodiments of this application, the liquid cooling device 500 may be configured to separately dissipate heat for the power battery 610 of the electric vehicle 600 and the charging cable 433 of the charger 430. This can meet heat dissipation requirements of both the charger 430 and the power battery 610 during high-power charging, improve efficiency and safety of charging the electric vehicle 600 by the charging pile 300, and help ensure normal high-power charging of the electric vehicle 600. In addition, because the power battery 610 and the charging cable 433 share the liquid cooling device 500 for heat dissipation, the liquid cooling device 500 can have high utilization, to facilitate cost optimization of the charging pile 300.

The following describes a structure of the liquid cooling device 500 in detail with reference to the accompanying drawings.

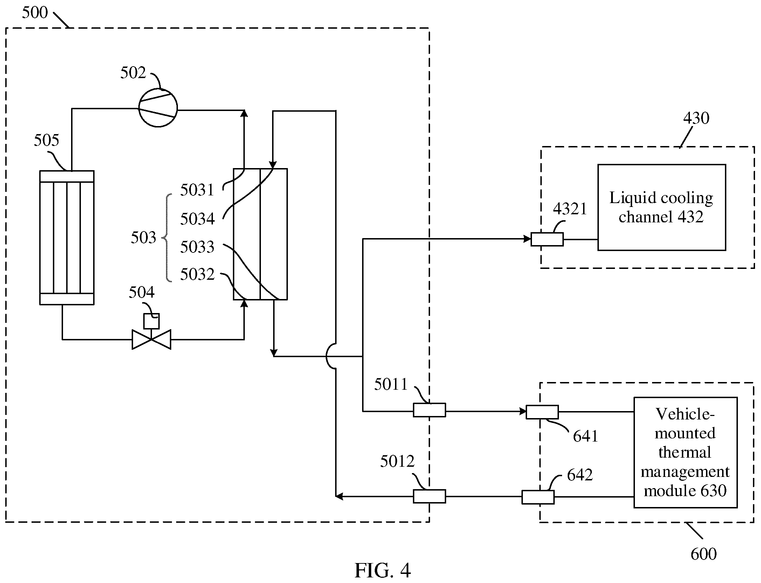

FIG. 4 is a diagram of a structure of the liquid cooling device 500 according to an embodiment of this application.

Refer to FIG. 4. The liquid cooling device 500 includes a first compressor 502, a first heat exchanger 503, a first expansion valve 504, and a second heat exchanger 505 that are sequentially connected. During specific implementation, the first compressor 502, the first heat exchanger 503, the first expansion valve 504, and the second heat exchanger 505 are connected through a refrigerant pipeline. In embodiments of this application, the refrigerant pipeline is a pipeline for circulation of a refrigerant, and the refrigerant may be, for example, Freon or a liquid cooling compound.

The first heat exchanger 503 includes a first refrigerant path and a first coolant path. The first refrigerant path is connected between the first compressor 502 and the first expansion valve 504, and the first refrigerant path is configured to exchange heat with the first coolant path.

Specifically, as shown in FIG. 4, a liquid outlet 5031 of the first refrigerant channel is connected to an inlet of the first compressor 502, an outlet of the first compressor 502 is connected to a liquid inlet of the second heat exchanger 505, a liquid outlet of the second heat exchanger 505 is connected to a first valve port of the first expansion valve 504 (for example, a left valve port of the first expansion valve 504 shown in FIG. 4), and a second valve port of the first expansion valve 504 (for example, a right valve port of the first expansion valve 504 shown in FIG. 4) is connected to a liquid inlet 5032 of the first refrigerant channel. In this way, a refrigerant circulation loop is formed, so that the refrigerant circulates in a sequence of the first compressor 502, the second heat exchanger 505, the first expansion valve 504, and the first heat exchanger 503. Therefore, the refrigerant flowing in the first refrigerant path may exchange heat with the coolant flowing in the first coolant path, to cool the coolant flowing in the first coolant path.

In addition, a liquid outlet 5033 of the first coolant path is configured to connect to the liquid injection port 641 of the electric vehicle and the liquid inlet 4321 of the liquid cooling channel 432, and a liquid inlet 5034 of the first coolant path is configured to connect to the liquid return port 642 of the electric vehicle. For example, as shown in FIG. 4, the liquid outlet 5033 of the first coolant path may be connected to the liquid outlet connector 5011 of the liquid cooling connector 501, and the liquid inlet 5034 of the first coolant path may be connected to the liquid inlet connector 5012 of the liquid cooling connector 501. Therefore, the first coolant path may be connected to the liquid injection port 641 of the electric vehicle and the liquid return port 642 of the electric vehicle via the liquid cooling connector 501.

During specific implementation, the coolant obtained after cooling in the first coolant path flows into the vehicle-mounted thermal management module 630 of the electric vehicle 600 through the liquid injection port 641 of the electric vehicle, and the coolant in the vehicle-mounted thermal management module 630 flows back to the first coolant path through the liquid return port 642 of the electric vehicle. In this way, the liquid cooling device 500 can cyclically dissipate heat for the power battery 610 through circulation of the coolant between the first coolant path and the vehicle-mounted thermal management module 630. In addition, the coolant obtained after cooling in the first coolant path may also flow into the liquid cooling channel 432 through the liquid inlet 4321 of the liquid cooling channel 432, to absorb heat generated by the charging cable 433, so as to dissipate heat for the charging cable 433.

For example, the first heat exchanger 503 is an evaporator, and the second heat exchanger 505 is a condenser.

During specific implementation, in some embodiments, when an ambient temperature of the liquid cooling device 500 is lower than a preset temperature, the first compressor 502 is in an off state. The first coolant path is configured to exchange heat with air in an environment in which the liquid cooling device 500 is located.

It should be understood that, in winter, when the temperature is low, the ambient temperature of the liquid cooling device 500 is low. In this case, the first compressor 502 may be in the off state, and the coolant in the first coolant path directly transfers heat to the cold air in the environment in which the first compressor is located. In other words, the coolant in the first coolant path is cooled in a natural cooling manner. In this way, energy consumption of the liquid cooling device 500 can be reduced while the liquid cooling device 500 dissipates heat for both the power battery 610 of the electric vehicle 600 and the charging cable 433.

It should be further understood that, in embodiments of this application, to implement cyclic heat dissipation of the charging cable 433 by the liquid cooling device 500, the coolant that is in the liquid cooling channel 432 and that absorbs heat flows back to the liquid cooling device 500.

The following describes, with reference to the accompanying drawings, a specific manner in which the coolant in the liquid cooling channel 432 flows back to the liquid cooling device 500.

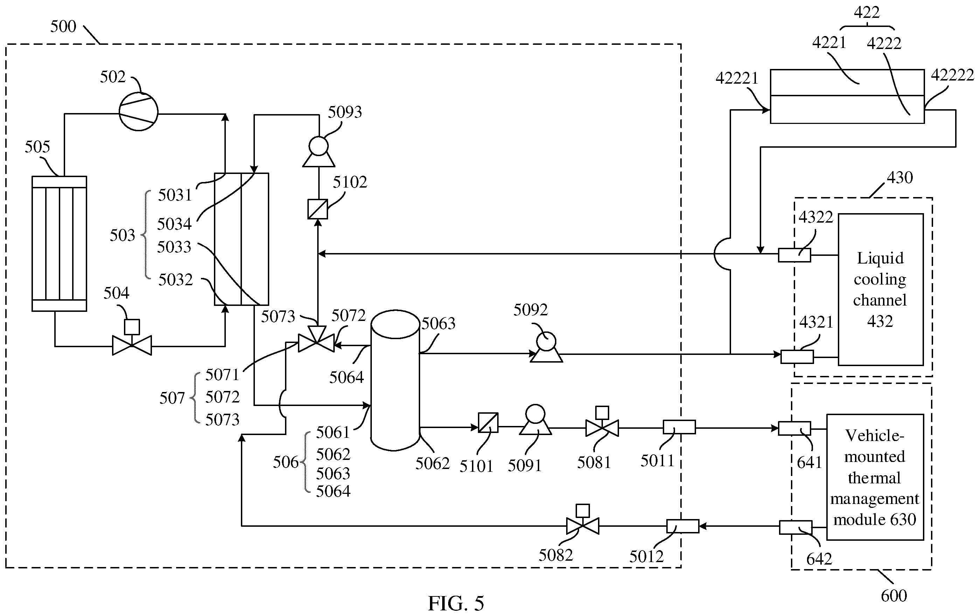

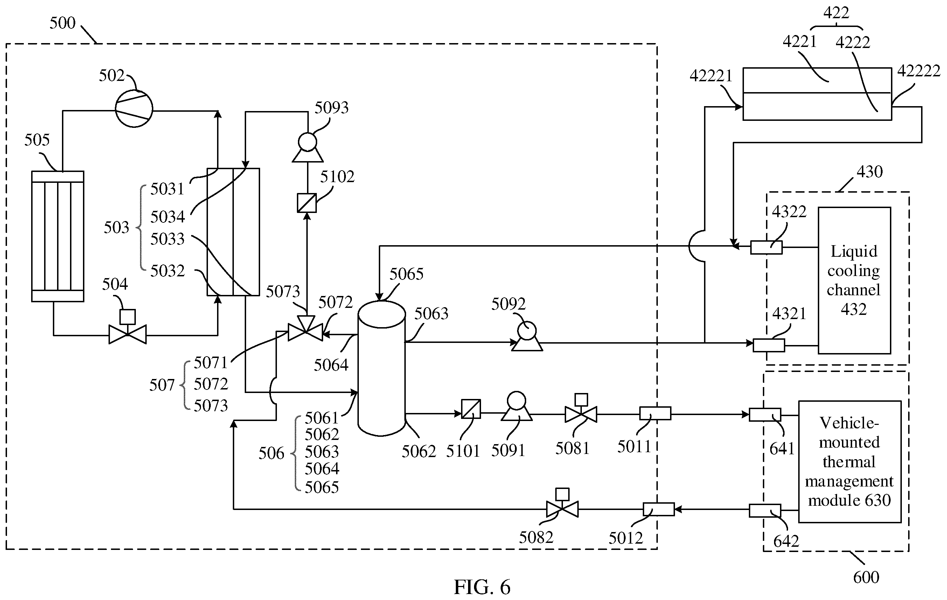

FIG. 5 and FIG. 6 are respectively diagrams of specific structures of an example of the liquid cooling device 500 shown in FIG. 4 according to an embodiment of this application.

With reference to FIG. 5 and FIG. 6, in some embodiments, the liquid cooling device 500 further includes a liquid storage tank 506, and the liquid storage tank 506 is configured to store coolant.

The liquid outlet 5033 of the first coolant path in the first heat exchanger 503 is configured to connect to the liquid injection port 641 of the electric vehicle and the liquid inlet 4321 of the liquid cooling channel 432 via the liquid storage tank 506. Specifically, a first liquid inlet 5061 of the liquid storage tank is connected to the liquid outlet 5033 of the first coolant path, a first liquid outlet 5062 of the liquid storage tank is configured to connect to the liquid injection port 641 of the electric vehicle, and a second liquid outlet 5063 of the liquid storage tank is configured to connect to the liquid inlet 4321 of the liquid cooling channel 432. For example, the first liquid outlet 5062 of the liquid storage tank is connected to the liquid outlet connector 5011 of the liquid cooling connector 501, to connect to the liquid injection port 641 of the electric vehicle via the liquid cooling connector 501.

Based on the foregoing design, the coolant obtained after cooling in the first coolant path of the first heat exchanger 503 may flow into the liquid storage tank 506 in advance for storage. When the electric vehicle 600 and/or the charging cable 433 of the charger 430 needs to dissipate heat, the coolant with a low temperature stored in the liquid storage tank 506 may quickly flow into the electric vehicle 600 and/or the liquid cooling channel 432. This can improve timeliness of heat dissipation performed by the liquid cooling device 500 on the power battery 610 of the electric vehicle 600 and the charging cable 433 of the charger 430, to further improve efficiency of charging the electric vehicle 600 by the charging pile 300.

Further, for the electric vehicle 600, as shown in FIG. 5 and FIG. 6, the coolant in the electric vehicle 600 may directly flow back to the first coolant path of the first heat exchanger 503. In other words, the first heat exchanger 503 forms a coolant circulation loop with the electric vehicle 600 through the liquid storage tank 506.

For the charger 430, in an example, as shown in FIG. 5, the liquid inlet 5034 of the first coolant path in the first heat exchanger 503 is configured to connect to the liquid outlet of the liquid cooling channel of the charger 430. The liquid outlet of the liquid cooling channel of the charger 430 is a liquid outlet 4322 of the liquid cooling channel 432 in the liquid cooling cable.

Based on the foregoing design, after the coolant in the liquid storage tank 506 flows into the liquid cooling channel 432 and absorbs heat generated by the charging cable 433, the coolant in the liquid cooling channel 432 may directly flow back to the first coolant path of the first heat exchanger 503. That is, similar to the electric vehicle 600, the first heat exchanger 503 forms a coolant circulation loop with the liquid cooling channel 432 through the liquid storage tank 506, so that the liquid cooling device 500 cyclically dissipates heat for the charging cable 433 in the charger 430.

In the foregoing technical solution, the coolant flowing back from the electric vehicle 600 and the liquid cooling channel 432 is cooled through the first coolant path of the first heat exchanger 503 and then flows into the liquid storage tank 506. Therefore, the coolant in the liquid storage tank 506 can maintain a low temperature. This helps improve a cooling storage capability of the liquid storage tank 506.

In another example, as shown in FIG. 6, a second liquid inlet 5065 of the liquid storage tank is configured to connect to the liquid outlet 4322 of the liquid cooling channel 432. Based on the foregoing design, after the coolant in the liquid storage tank 506 flows into the liquid cooling channel 432 and absorbs heat generated by the charging cable 433, the coolant in the liquid cooling channel 432 directly flows back to the liquid storage tank 506, and is mixed with the coolant that enters the liquid storage tank 506 through the first coolant path. The coolant that is in the liquid storage tank 506 and that is obtained after mixing and cooling flows into the liquid cooling channel 432 again through the second liquid outlet 5063 of the liquid storage tank. In other words, the liquid storage tank 506 serves as both a water supply tank and a water return tank of the charger 430.

In the foregoing technical solution, a coolant circulation loop is directly formed between the liquid storage tank 506 and the liquid cooling channel 432, so that a circulation path of the coolant between the liquid cooling device 500 and the liquid cooling channel 432 can be reduced, to help improve efficiency of dissipating heat for the charging cable 433 by the liquid cooling device 500.

With reference to FIG. 3 to FIG. 5, in some embodiments, the charging pile 300 further includes a switch and a fourth heat exchanger 422. The output ends of the plurality of charging modules 411 are connected to the charger 430 through the switch, and the switch is configured to control connection and disconnection of a circuit between the plurality of charging modules 411 and the charger 430. In addition, the fourth heat exchanger 422 includes a first gas path 4221 and a second coolant path 4222, and the second coolant path 4222 is configured to exchange heat with the first gas path 4221. An inlet of the first gas path 4221 and an outlet of the first gas path 4221 communicate with an environment in which the switch is located, and the second coolant path 4222 is configured to receive the coolant output by the liquid cooling device 500.

For example, both the switch and the fourth heat exchanger 422 may be located in a power distribution compartment of the charging terminal 420 shown in FIG. 2. The power distribution compartment may further include a copper bar, a shunt, and a fuse. The switch, the shunt, and the fuse are all fastened to the copper bar and connected between the plurality of charging modules 411 and the charger 430. The shunt and the fuse are respectively configured to perform current detection and overcurrent protection on the circuit between the plurality of charging modules 411 and the charger 430.

Based on the foregoing design, gas in the environment in which the switch is located may flow in the first gas path 4221 after the gas absorbs heat generated by the switch, and the second coolant path 4222 may cool the gas flowing in the first gas path 4221 by using the coolant provided by the liquid cooling device, to implement heat dissipation of the switch by the liquid cooling device 500.

Further, to implement cyclic heat dissipation of the switch by the liquid cooling device 500, the liquid cooling device 500 also needs to form a coolant circulation loop with the second coolant path 4222. The liquid cooling device 500 may be connected to the second coolant path 4222 in a similar manner of connecting to the liquid cooling channel 432 of the charger 430.

Specifically, as shown in FIG. 5 and FIG. 6, the second liquid outlet 5063 of the liquid storage tank is further configured to connect to a liquid inlet 42221 of the second coolant path of the fourth heat exchanger 422. In addition, as shown in FIG. 5, the liquid inlet 5034 of the first coolant path of the first heat exchanger 503 is configured to connect to a liquid outlet 42222 of the second coolant path of the fourth heat exchanger 422. Alternatively, as shown in FIG. 6, the second liquid inlet 5065 of the liquid storage tank is configured to connect to a liquid outlet 42222 of the second coolant path of the fourth heat exchanger 422.

Based on the foregoing design, the first heat exchanger 503 forms a coolant circulation loop with the second coolant path 4222 through the liquid storage tank 506, or a coolant circulation loop is directly formed between the liquid storage tank 506 and the second coolant path 4222. During actual application, the gas in the environment in which the switch is located may flow in the first gas path 4221 after the gas absorbs the heat generated by the switch, and the second coolant path 4222 may cool the gas flowing in the first gas path 4221, to implement cyclic heat dissipation of the switch by the liquid cooling device 500.

It should be understood that, the fourth heat exchanger 422 may be disposed close to the switch to help the gas flowing in the first gas path 4221 absorb the heat generated by the switch.

For example, the charging pile 300 further includes a fan (not shown in the figure). The fan is disposed on one side of the fourth heat exchanger 422, and an air exhaust vent of the fan faces the first gas path 4221, to accelerate gas flowing in the first gas path 4221. In this way, a speed at which the gas absorbs the heat of the switch is increased, thereby improving heat dissipation efficiency of the switch.

In the charging pile 300 provided in embodiments of this application, the liquid cooling device 500 may be configured to dissipate heat for the power battery 610 of the electric vehicle 600 and the charging cable 433 of the charger 430, and may be further configured to dissipate heat for a power distribution component 421. This can further improve utilization of the liquid cooling device 500, thereby facilitating cost optimization of the charging pile 300.

Still with reference to FIG. 5 and FIG. 6, in some embodiments, a third liquid outlet 5064 of the liquid storage tank is connected to the liquid inlet 5034 of the first coolant path of the first heat exchanger 503.

Based on the foregoing design, a coolant circulation loop is formed between the liquid storage tank 506 and the first coolant path through the third liquid outlet 5064 of the liquid storage tank and the first liquid inlet 5061 of the liquid storage tank. In this way, the liquid cooling device 500 can cool the coolant in the liquid storage tank 506 through circulation of the coolant in the liquid storage tank 506 and the first coolant path.

Specifically, when the charger 430 does not supply electric energy to the electric vehicle 600, the liquid storage tank 506 may not provide coolant for the electric vehicle 600 and the liquid cooling channel 432. In other words, the first liquid outlet 5062 of the liquid storage tank and the second liquid outlet 5063 of the liquid storage tank may not output coolant. In this case, the coolant in the liquid storage tank 506 may flow into the first coolant path through the third liquid outlet 5064 of the liquid storage tank for cooling, and the coolant obtained after cooling flows into the liquid storage tank 506 again through the first liquid inlet 5061 of the liquid storage tank.

In this way, the coolant in the liquid storage tank 506 can maintain a low temperature, thereby improving a cooling storage capability of the liquid storage tank 506. This helps improve timeliness and effect of heat dissipation performed by the liquid cooling device 500 on the power battery 610 of the electric vehicle 600 and the charging cable 433 of the charger 430.

Further, still with reference to FIG. 5 and FIG. 6, in some embodiments, the liquid cooling device 500 further includes a three-way valve 507. A first valve port 5071 of the three-way valve is configured to connect to the liquid return port 642 of the electric vehicle, a second valve port 5072 of the three-way valve is connected to the third liquid outlet 5064 of the liquid storage tank, and a third valve port 5073 of the three-way valve is connected to the liquid inlet 5034 of the first coolant path.

Based on the foregoing design, a flow channel of the coolant may be switched by adjusting on/off states of different valve ports of the three-way valve 507, so that the first refrigerant path in the first heat exchanger 503 exchanges heat with the coolant flowing out of the electric vehicle 600, or the first refrigerant path exchange heat with the coolant flowing out of the liquid storage tank 506.

For example, in an example, the three-way valve 507 is configured to: when no coolant is output from the first liquid outlet 5062 of the liquid storage tank and the second liquid outlet 5063 of the liquid storage tank, connect a path between the liquid inlet 5034 of the first coolant path and the third liquid outlet 5064 of the liquid storage tank, and disconnect a path between the liquid inlet 5034 of the first coolant path and the liquid return port 642 of the electric vehicle.

Specifically, when the charger 430 does not charge the electric vehicle 600, the first liquid outlet 5062 of the liquid storage tank and the second liquid outlet 5063 of the liquid storage tank may not output the coolant to the electric vehicle 600 and the liquid cooling channel 432. In this case, the path between the second valve port 5072 of the three-way valve and the third valve port 5073 of the three-way valve is connected, and the path between the first valve port 5071 of the three-way valve and the third valve port 5073 of the three-way valve is disconnected, so that the coolant in the liquid storage tank 506 flows into the first coolant path through the three-way valve 507 for cooling, and then the coolant in the liquid storage tank 506 maintains a low temperature.

In this way, when the charger 430 charges the electric vehicle 600, the coolant with the low temperature stored in the liquid storage tank 506 may be quickly output to the electric vehicle 600 and the liquid cooling channel 432 through the first liquid outlet 5062 of the liquid storage tank and the second liquid outlet 5063 of the liquid storage tank, to improve timeliness and effect of heat dissipation performed by the liquid cooling device 500 on the power battery 610 and the charging cable 433.

In another example, the three-way valve 507 is configured to: when coolant is output from the first liquid outlet 5062 of the liquid storage tank, connect a path between the liquid inlet 5034 of the first coolant path and the liquid return port 642 of the electric vehicle, and disconnect a path between the liquid inlet 5034 of the first coolant path and the third liquid outlet 5064 of the liquid storage tank.

Specifically, when the charger 430 charges the electric vehicle 600, the first liquid outlet 5062 of the liquid storage tank outputs the coolant to the electric vehicle 600. In this case, the path between the first valve port 5071 of the three-way valve and the third valve port 5073 of the three-way valve is connected, and the path between the second valve port 5072 of the three-way valve and the third valve port 5073 of the three-way valve is disconnected, so that the first refrigerant path in the first heat exchanger 503 exchanges heat with only the coolant flowing out of the electric vehicle 600, thereby improving efficiency of heat dissipation performed by the liquid cooling device 500 on the power battery 610.

It should be understood that, during specific implementation, to improve working efficiency of the liquid storage tank 506, in the liquid storage tank 506, a liquid inlet and a liquid outlet for flowing of high-temperature coolant and a liquid inlet and a liquid outlet for flowing of low-temperature coolant may be disposed in different chambers of the liquid storage tank 506.

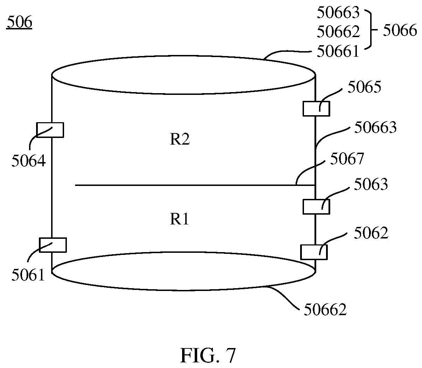

For example, refer to FIG. 7. FIG. 7 is a diagram of a specific structure of an example of the liquid storage tank 506 shown in FIG. 5 and FIG. 6.

As shown in FIG. 7, in some embodiments, the liquid storage tank 506 includes a tank body 5066, and the tank body 5066 includes two chambers that communicate with each other. To be specific, the tank body 5066 includes a chamber R1 and a chamber R2 that communicate with each other, and the chamber R1 is located below the chamber R2 in a gravity direction.

During specific implementation, as shown in FIG. 7, the tank body 5066 includes a top plate 50661, a bottom plate 50662, and a side plate 50663, and the liquid storage tank 506 further includes a partition plate 5067. The top plate 50661 and the bottom plate 50662 are disposed opposite to each other in the gravity direction, and the side plate 50663 is fastened between the top plate 50661 and the bottom plate 50662, so that the top plate 50661, the bottom plate 50662, and the side plate 50663 enclose internal space of the tank body 5066, and the partition plate 5067 is located inside the internal space. Therefore, the top plate 50661, a part that is of the side plate 50663 and that is close to the top plate 50661, and the partition plate 5067 mutually enclose the chamber R1, and the bottom plate 50662, a part that is of the side plate 50663 and that is close to the bottom plate 50662, and the partition plate 5067 mutually enclose the chamber R2.

In an example, as shown in FIG. 7, there is a spacing between the partition plate 5067 and an inner wall of the side plate 50663, so that the chamber R1 and the chamber R2 communicate with each other through the spacing. In another example, the partition plate 5067 includes one or more through holes, and each through hole penetrates the partition plate 5067 in the gravity direction. The chamber R1 and the chamber R2 communicate with each other through the one or more through holes.

It should be understood that the specific structure of the liquid storage tank 506 is merely an example. In the foregoing embodiment, the structure of the liquid storage tank 506 can enable the liquid storage tank 506 to have two chambers arranged in the gravity direction, and the two chambers communicate with each other.

Still refer to FIG. 7. In some embodiments, the first liquid inlet 5061 of the liquid storage tank, the first liquid outlet 5062 of the liquid storage tank, and the second liquid outlet 5063 of the liquid storage tank are located in the tank body 5066 corresponding to the chamber R1, and the first liquid inlet 5061 of the liquid storage tank, the first liquid outlet 5062 of the liquid storage tank, and the second liquid outlet 5063 of the liquid storage tank communicate with the chamber R1. The third liquid outlet 5064 of the liquid storage tank is located in the tank body 5066 corresponding to the chamber R2, and the third liquid outlet 5064 of the liquid storage tank communicates with the chamber R2.

For example, the first liquid inlet 5061 of the liquid storage tank, the first liquid outlet 5062 of the liquid storage tank, and the second liquid outlet 5063 of the liquid storage tank are located at the part that is of the side plate 50663 and that is close to the bottom plate 50662, and the third liquid outlet 5064 of the liquid storage tank is located at the part that is of the side plate 50663 and that is close to the top plate 50661.

It should be understood that the first liquid inlet 5061 of the liquid storage tank, the first liquid outlet 5062 of the liquid storage tank, and the second liquid outlet 5063 of the liquid storage tank are configured to flow coolant provided for the electric vehicle 600 and the liquid cooling channel 432, and the third liquid outlet 5064 of the liquid storage tank is configured to flow high-temperature coolant in the liquid storage tank 506 into the first coolant path for cooling. Therefore, temperatures of the coolant flowing through the first liquid inlet 5061 of the liquid storage tank, the first liquid outlet 5062 of the liquid storage tank, and the second liquid outlet 5063 of the liquid storage tank are lower than a temperature of the coolant flowing through the third liquid outlet 5064 of the liquid storage tank. In other words, in the liquid storage tank 506, the liquid inlet and the liquid outlet for flowing of the low-temperature coolant communicate with the chamber R1, and the liquid inlet and the liquid outlet for flowing of the high-temperature coolant communicate with the chamber R2. That is, in the liquid storage tank 506, the liquid inlet and the liquid outlet for flowing of the low-temperature coolant are disposed below the liquid inlet and the liquid outlet for flowing of the high-temperature coolant.

During actual application, the low-temperature coolant in the chamber R2 flows to the lower chamber R1, and the high-temperature coolant in the chamber R1 flows to the upper chamber R2. Therefore, in embodiments of this application, the liquid inlet and the liquid outlet that are in the liquid storage tank 506 and that are used to flow the low-temperature coolant are disposed below the liquid inlet and the liquid outlet that are used to flow the high-temperature coolant, so that mixed convection of the high-temperature coolant and the low-temperature coolant in the liquid storage tank 506 can be reduced, to reduce impact of the high-temperature coolant on the low-temperature coolant, and improve heat dissipation efficiency of the liquid cooling device 500.

In an example, as shown in FIG. 7, when the second liquid inlet 5065 of the liquid storage tank is configured to connect to the liquid outlet 4322 of the liquid cooling channel 432, because coolant that is in the liquid cooling channel 432 and that absorbs heat of the charging cable 433 flows into the liquid storage tank 506 through the second liquid inlet 5065 of the liquid storage tank, the second liquid inlet 5065 of the liquid storage tank may be understood as the liquid inlet used to flow the high-temperature coolant in the liquid storage tank 506, and the second liquid inlet 5065 of the liquid storage tank is located in the tank body 5066 corresponding to the chamber R2.

Based on the foregoing design, mixed convection of the high-temperature coolant and the low-temperature coolant in the liquid storage tank 506 can be reduced, to reduce impact of the high-temperature coolant on the low-temperature coolant, and improve heat dissipation efficiency of the liquid cooling device 500.

It should be understood that, the foregoing describes only a main structure of the liquid storage tank 506. During actual application, some other structures may be added in the liquid storage tank 506 according to actual production and design requirements. For example, the liquid storage tank 506 further includes an electric heater. The electric heater is configured to heat the coolant in the liquid storage tank 506 in a scenario in which an ambient temperature is low, such as winter, to ensure normal use of the liquid storage tank 506 in a low-temperature environment. For another example, the liquid storage tank 506 further includes a safety relief valve. The safety relief valve is configured to release the excessive pressure in the liquid storage tank 506, to prevent the liquid storage tank 506 from exploding or being damaged.

The foregoing describes the specific structure of the liquid storage tank 506 in the liquid cooling device 500 with reference to the accompanying drawings, and the following continues to describe another structure in the liquid cooling device 500 with reference to the accompanying drawings.

Still with reference to FIG. 5 and FIG. 6, in some embodiments, the liquid cooling device 500 further includes two solenoid valves: a solenoid valve 5081 and a solenoid valve 5082. A first valve port of the solenoid valve 5081 (for example, a left valve port of the solenoid valve 5081 shown in FIG. 5 and FIG. 6) is connected to the first liquid outlet 5062 of the liquid storage tank, and a second valve port of the solenoid valve 5081 (for example, a right valve port of the solenoid valve 5081 shown in FIG. 5 and FIG. 6) is configured to connect to the liquid injection port 641 of the electric vehicle. For example, the second valve port of the solenoid valve 5081 may be connected to the liquid outlet connector 5011 of the liquid cooling connector 501, to connect to the liquid injection port 641 of the electric vehicle via the liquid cooling connector 501.

Similarly, a first valve port of the solenoid valve 5082 (for example, a left valve port of the solenoid valve 5082 shown in FIG. 5 and FIG. 6) is connected to the liquid inlet 5034 of the first coolant path, and a second valve port of the solenoid valve 5082 (for example, a right valve port of the solenoid valve 5082 shown in FIG. 5 and FIG. 6) is configured to connect to the liquid return port 642 of the electric vehicle. For example, the second valve port of the solenoid valve 5081 may be connected to the liquid inlet connector 5012 of the liquid cooling connector 501, to connect to the liquid return port 642 of the electric vehicle via the liquid cooling connector 501.

Based on the foregoing design, on and off of the solenoid valve 5081 and the solenoid valve 5082 may be switched according to whether the liquid cooling device 500 provides coolant for the electric vehicle 600. For example, when the liquid cooling device 500 is not connected to the electric vehicle 600, the charging pile 300 controls the solenoid valve 5081 and the solenoid valve 5082 to be off, to prevent leakage of the coolant in the liquid cooling device 500. For another example, when the liquid cooling device 500 is connected to the electric vehicle 600, the charging pile 300 controls the solenoid valve 5081 and the solenoid valve 5082 to be on, so that the coolant circulates between the liquid cooling device 500 and the electric vehicle 600, to implement heat dissipation of the power battery 610 by the liquid cooling device 500.

Still with reference to FIG. 5 and FIG. 6, in some embodiments, to enable the coolant in the liquid storage tank 506 to flow into the electric vehicle 600 and the liquid cooling channel 432, the liquid cooling device 500 further includes a first water pump 5091 and a second water pump 5092.

The first water pump 5091 is configured to be connected between the first liquid outlet 5062 of the liquid storage tank and the liquid injection port 641 of the electric vehicle. For example, the first water pump 5091 may be connected between the first liquid outlet 5062 of the liquid storage tank and the liquid outlet connector 5011 of 501. The second water pump 5092 is configured to be connected between the second liquid outlet 5063 of the liquid storage tank and the liquid outlet 4322 of the liquid cooling channel 432, or the second water pump 5092 is configured to be connected between the liquid inlet 5034 of the first coolant path and the liquid inlet 4321 of the liquid cooling channel, or the second water pump 5092 is configured to be connected between the second liquid inlet 5065 of the liquid storage tank and the liquid inlet 4321 of the liquid cooling channel.

Based on the foregoing design, the first water pump 5091 may drive the coolant in the liquid storage tank 506 to flow into the electric vehicle 600, and the second water pump 5092 may drive the coolant in the liquid storage tank 506 to flow into the liquid cooling channel 432, so that the liquid cooling device 500 dissipates heat for the power battery 610 and the charging cable 433.

It should be understood that, that both the first water pump 5091 and the second water pump 5092 are disposed in the liquid cooling device 500 is merely an example. For example, in some other embodiments, the second water pump 5092 may be disposed in the charging terminal 420 connected to the charger 430. In other words, the liquid cooling device 500 may include only the first water pump 5091, and does not include the second water pump 5092.

Still with reference to FIG. 5 and FIG. 6, in some embodiments, to enable the coolant in the liquid cooling device 500 to flow in the first coolant path of the first heat exchanger 503, the liquid cooling device 500 further includes a third water pump 5093. The liquid inlet 5034 of the first coolant path is configured to connect to the liquid return port 642 of the electric vehicle and the third liquid outlet 5064 of the liquid storage tank through the third water pump 5093.

For example, as shown in FIG. 5 and FIG. 6, the third water pump 5093 is connected between the liquid inlet 5034 of the first coolant path and the third valve port 5073 of the three-way valve, to connect the liquid return port 642 of the electric vehicle and the third liquid outlet 5064 of the liquid storage tank through the three-way valve 507.

Based on the foregoing design, the third water pump 5093 may drive the coolant flowing out of the electric vehicle 600 and the coolant flowing out of the liquid storage tank 506 to flow into the first coolant path, so that the liquid cooling device 500 dissipates heat for the power battery 610 and the liquid storage tank 506.

Further, as shown in FIG. 5, when the liquid inlet 5034 of the first coolant path is configured to connect to the liquid outlet 4322 of the liquid cooling channel 432, a fourth water pump 5094 is further connected between the liquid inlet 5034 of the first coolant path and the liquid outlet 4322 of the liquid cooling channel 432. In this way, the third water pump 5093 may further drive the coolant flowing out of the liquid cooling channel 432 to flow into the first coolant path, so that the liquid cooling device 500 dissipates heat for the charging cable 433.

Still with reference to FIG. 5 and FIG. 6, in some embodiments, the liquid cooling device 500 further includes at least one of a first filter 5101 and a second filter 5102. The first filter 5101 is configured to be connected between the liquid outlet 5033 of the first coolant path and the liquid injection port 641 of the electric vehicle, and the second filter 5102 is configured to be connected between the liquid inlet 5034 of the first coolant path and the liquid return port 642 of the electric vehicle.

For example, as shown in FIG. 5 and FIG. 6, the liquid cooling device 500 includes the first filter 5101 and the second filter 5102. In addition, during specific implementation, the first filter 5101 is connected between the first liquid outlet 5062 of the liquid storage tank and the liquid outlet connector 5011 of the liquid cooling connector 501, and the second filter 5102 is connected between the third valve port 5073 of the three-way valve and the third water pump 5093.

Based on the foregoing design, the first filter 5101 may filter out impurities in the coolant transferred from the liquid cooling device 500 to the electric vehicle 600, to control cleanliness of the coolant that flows from the liquid cooling device 500 to the electric vehicle 600. In addition, the second filter 5102 may filter out impurities in the coolant transferred from the electric vehicle 600 to the liquid cooling device 500, to control cleanness of the coolant that flows from the electric vehicle 600 to the liquid cooling device 500.

It should be understood that the foregoing describes only a main structure of the liquid cooling device 500. During actual application, some structures may be added or removed in the liquid cooling device 500 according to actual production and design requirements. For example, the liquid cooling device 500 further includes some sensors, for example, further includes a temperature sensor, a pressure sensor, or a flow sensor, to separately monitor a temperature, pressure, and flow of circulating coolant in the liquid cooling device 500, which are not described in detail herein.

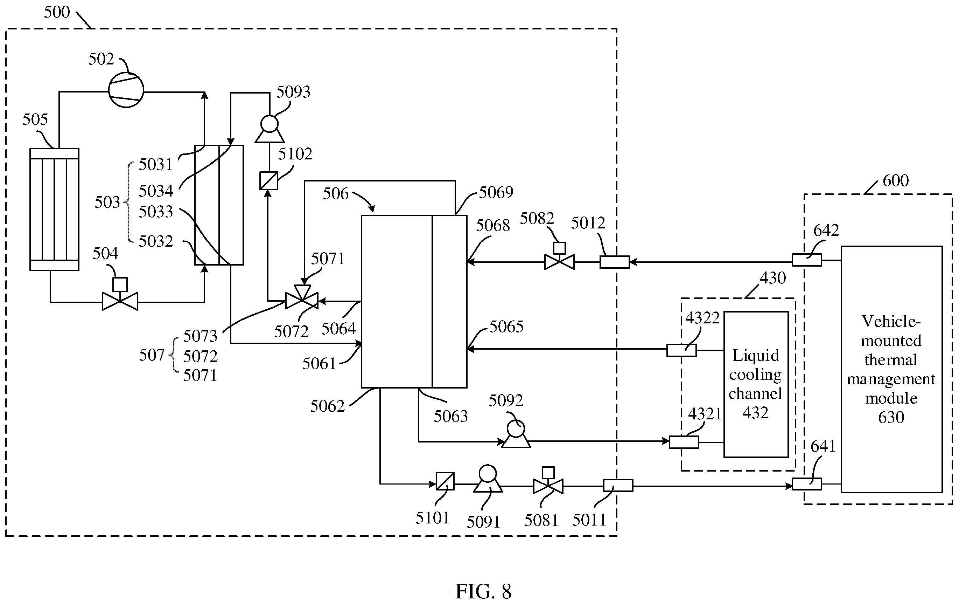

FIG. 8 is a diagram of a specific structure of another example of the liquid cooling device 500 shown in FIG. 4 according to an embodiment of this application.

Different from the liquid inlet 5034 that is of the first coolant path in the embodiments shown in FIG. 5 to FIG. 7 and that is configured to directly connect to the liquid return port 642 of the electric vehicle, in the embodiment shown in FIG. 8, the liquid inlet 5034 of the first coolant path is configured to connect to the liquid return port 642 of the electric vehicle through the liquid storage tank 506. A third liquid inlet 5068 of the liquid storage tank is configured to connect to the liquid return port 642 of the electric vehicle, and a fourth liquid outlet 5069 of the liquid storage tank is connected to the liquid inlet 5034 of the first coolant path.

During specific implementation, the third liquid inlet 5068 of the liquid storage tank may be connected to the liquid inlet connector 5012 of the liquid cooling connector 501, to connect to the liquid return port 642 of the electric vehicle via the liquid cooling connector 501. In addition, the fourth liquid outlet 5069 of the liquid storage tank is connected to the first valve port 5071 of the three-way valve, so that the fourth liquid outlet 5069 of the liquid storage tank may be connected to the liquid inlet 5034 of the first coolant path through the first valve port 5071 of the three-way valve and the third valve port 5073 of the three-way valve.

Based on the foregoing design, the liquid storage tank 506 not only serves as a water supply tank for both the charger 430 and the electric vehicle 600, but also serves as a water return tank for both the charger 430 and the electric vehicle 600. This can keep a capacity of the coolant in the liquid storage tank 506 in a stable state, thereby stabilizing a pressure inside the liquid storage tank 506.

It should be understood that, during specific implementation, because the temperature of the coolant flowing from the electric vehicle 600 to the liquid storage tank 506 is high, to enable the coolant provided by the liquid storage tank 506 for the electric vehicle 600 and the liquid cooling channel 432 to dissipate heat for the power battery 610 and the charging cable 433, the high-temperature coolant and the low-temperature coolant in the liquid storage tank 506 may flow in the mutually isolated chambers.

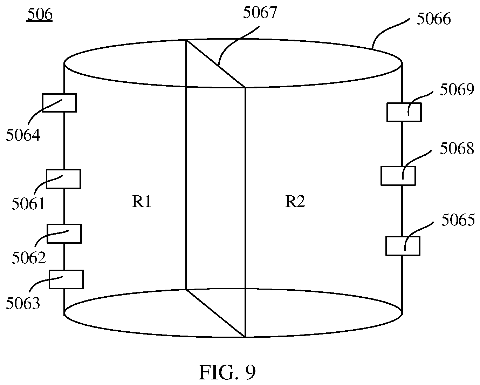

For example, refer to FIG. 9. FIG. 9 is a diagram of a specific structure of an example of the liquid storage tank 506 shown in FIG. 8.

Different from the embodiment shown in FIG. 7, in the liquid storage tank 506 shown in FIG. 9, the chamber R1 and the chamber R2 do not communicate with each other. The first liquid inlet 5061 of the liquid storage tank, the first liquid outlet 5062 of the liquid storage tank, and the second liquid outlet 5063 of the liquid storage tank communicate with the chamber R1, and the third liquid inlet 5068 of the liquid storage tank and the fourth liquid outlet 5069 of the liquid storage tank communicate with the chamber R2.

Based on the foregoing design, the coolant flowing back from the electric vehicle 600 flows into the first coolant path through the chamber R2 of the liquid storage tank for cooling. Then, the coolant obtained after cooling in the first coolant path flows into the chamber R1 of the liquid storage tank, and then flows into the electric vehicle 600 and the liquid cooling channel 432.

In the foregoing technical solution, the low-temperature coolant that is in the liquid cooling device 500 and that is output to the electric vehicle 600 and the liquid cooling channel 432 may flow in the chamber R1, and the high-temperature coolant that flows back from the electric vehicle 600 to the liquid storage tank 506 may flow in the chamber R2. This can avoid mixing of the high-temperature coolant and the low-temperature coolant in the liquid storage tank 506, and help the liquid storage tank 506 stably output the low-temperature coolant to the electric vehicle 600 and the liquid cooling channel 432, to ensure that the liquid cooling device 500 can dissipate heat for the power battery 610 and the charging cable 433.

It should be understood that, in embodiments of this application, when the second liquid inlet 5065 of the liquid storage tank is configured to connect to the liquid outlet 4322 of the liquid cooling channel 432, because in a charging process of the electric vehicle 600, heat generated by the charging cable 433 is less than heat generated by the power battery 610, although the coolant flowing back from the liquid cooling channel 432 to the liquid storage tank 506 carries heat, the coolant may still be used to dissipate heat for the power battery 610. Therefore, during specific implementation, the second liquid inlet 5065 of the liquid storage tank may communicate with the chamber R1, or may communicate with the chamber R2.

When the second liquid inlet 5065 of the liquid storage tank communicates with the chamber R1, the coolant output from the liquid cooling channel 432 flows into the chamber R1, and is mixed with the coolant that enters the chamber R1 through the first coolant path. The coolant obtained after mixing and cooling in the chamber R1 flows into the electric vehicle 600 and the liquid cooling channel 432 again. In other words, a coolant circulation loop is directly formed between the liquid cooling channel 432 and the liquid storage tank 506.

When the second liquid inlet 5065 of the liquid storage tank communicates with the chamber R2, the coolant output from the liquid cooling channel 432 flows into the chamber R2, and flows into the first coolant path together with the coolant that is output from the electric vehicle 600 to the chamber R2 for cooling, and then flows into the chamber R1. This may enable the coolant in the chamber R1 to maintain a low temperature, to better meet heat dissipation requirements of the power battery 610 and the charging cable 433.

In some embodiments, the third liquid outlet 5064 of the liquid storage tank communicates with the chamber R1. Based on the foregoing design, a coolant circulation loop is formed between the chamber R1 and the first coolant path through the third liquid outlet 5064 of the liquid storage tank and the first liquid inlet 5061 of the liquid storage tank. Therefore, the coolant in the chamber R1 can be cooled through circulation of the coolant in the chamber R1 and the first coolant path, to improve a cooling storage capability of the chamber R1, and then better meet heat dissipation requirements of the power battery 610 and the charging cable 433.

During specific implementation, in an example, as shown in FIG. 9, the partition plate 5067 divides the interior of the tank body 5066 into the chamber R1 and the chamber R2 that do not communicate with each other. In another example, the tank body 5066 includes two sub-tank bodies, where internal space of one sub-tank body serves as the chamber R1, and internal space of the other sub-tank body serves as the chamber R2.

It should be understood that, for a part that is not described in detail and that is of the liquid cooling device 500 shown in FIG. 8 and FIG. 9, refer to the related descriptions of the embodiments shown in FIG. 5 to FIG. 7. Details are not described herein again.

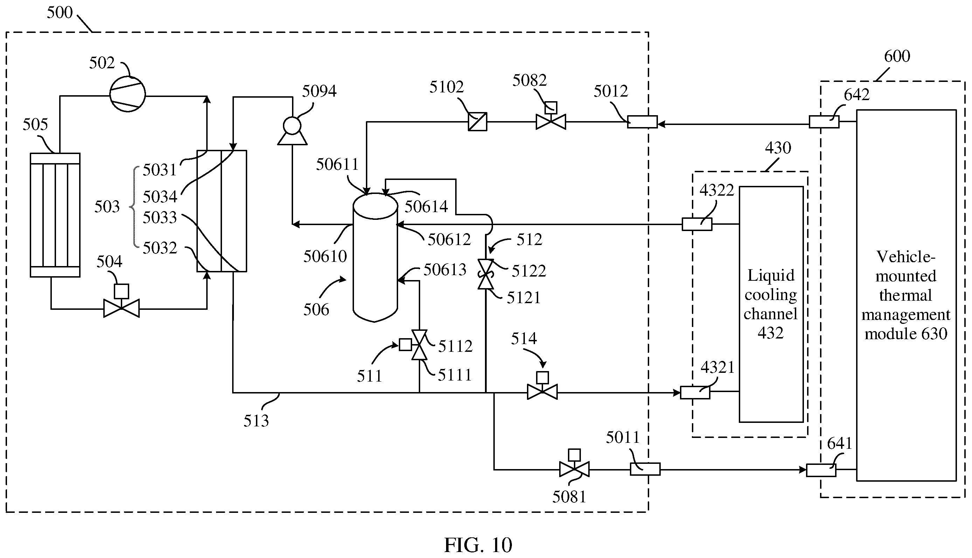

FIG. 10 is a diagram of a specific structure of still another example of the liquid cooling device 500 shown in FIG. 4 according to an embodiment of this application.

Different from the liquid outlet 5033 that is of the first coolant path shown in FIG. 5 to FIG. 9 and that is configured to connect to the liquid injection port 641 of the electric vehicle and the liquid inlet 4321 of the liquid cooling channel 432 through the liquid storage tank 506, in the liquid cooling device 500 shown in FIG. 10, the liquid outlet 5033 of the first coolant path is configured to directly connect to the liquid injection port 641 of the electric vehicle and the liquid inlet 4321 of the liquid cooling channel 432 without using the liquid storage tank 506. In addition, the liquid inlet 5034 of the first coolant path is configured to connect to the liquid return port 642 of the electric vehicle and the liquid outlet 4322 of the liquid cooling channel 432 through the liquid storage tank 506.

Specifically, as shown in FIG. 10, the first liquid outlet 50610 of the liquid storage tank is connected to the liquid inlet 5034 of the first coolant path, the first liquid inlet 50611 of the liquid storage tank is configured to connect to the liquid return port 642 of the electric vehicle, and the second liquid inlet 50612 of the liquid storage tank is configured to connect to the liquid outlet 4322 of the liquid cooling channel 432. For example, the first liquid inlet 50611 of the liquid storage tank is connected to the liquid inlet connector 5012 of the liquid cooling connector 501, to connect to the liquid return port 642 of the electric vehicle via the liquid cooling connector 501.

Based on the foregoing design, the liquid storage tank 506 is configured to store the coolant in the liquid cooling device 500. When the electric vehicle 600 and/or the charging cable 433 of the charger 430 needs to dissipate heat, the coolant stored in the liquid storage tank 506 may quickly cool down through the first coolant path of the first heat exchanger 503 and then flow into the electric vehicle 600 and/or the liquid cooling channel 432, so that the liquid cooling device 500 dissipates heat for the power battery 610 and the charging cable 433.

Still refer to FIG. 10. In some embodiments, to enable the coolant in the liquid storage tank 506 to flow into the electric vehicle 600 and the liquid cooling channel 432, the liquid cooling device 500 further includes the fourth water pump 5094. The fourth water pump 5094 is configured to be connected between the liquid outlet 5033 of the first coolant path and the liquid return port 642 of the electric vehicle, and between the liquid outlet 5033 of the first coolant path and the liquid outlet 4322 of the liquid cooling channel 432. Alternatively, the third water pump 5093 is connected between the first liquid outlet 50610 of the liquid storage tank and the liquid inlet 5034 of the first coolant path.

Based on the foregoing design, one fourth water pump 5094 can drive the coolant in the liquid storage tank 506 to flow into the electric vehicle 600 and the liquid cooling channel 432. In this way, the liquid cooling device 500 can dissipate heat for the power battery 610 and the charging cable 433, and a quantity of water pumps disposed in the liquid cooling device 500 is also reduced, to facilitate cost optimization of the liquid cooling device 500.

Still refer to FIG. 10. In some embodiments, the liquid cooling device 500 further includes a solenoid valve 511. A first valve port 5111 of the solenoid valve is connected to the liquid outlet 5033 of the first coolant path, and a second valve port 5112 of the solenoid valve is connected to the third liquid inlet 50613 of the liquid storage tank.

Based on the foregoing design, a coolant circulation loop may be formed between the liquid storage tank 506 and the first coolant path through the solenoid valve 511. In this way, the coolant circulates in the liquid storage tank 506 and the first coolant path, so that heat dissipation of the coolant in the liquid storage tank 506 may be implemented through the first coolant path, and the coolant in the liquid storage tank 506 maintains a low temperature, to improve a cooling storage capability of the liquid storage tank 506. In addition, during actual application, the circulation loop between the liquid storage tank 506 and the first coolant path may be connected or disconnected by adjusting an on/off state of the solenoid valve 511.

For example, in some embodiments, the liquid cooling device 500 is configured to: when no coolant is received through the first liquid inlet 50611 of the liquid storage tank and the second liquid inlet 50612 of the liquid storage tank, control the solenoid valve 511 to be turned on.

It should be understood that, in a high-temperature environment such as summer, a temperature of the coolant stored in the liquid storage tank 506 is high. As a result, when the charger 430 charges the electric vehicle 600, a temperature of the coolant stored in the liquid storage tank 506 is still high after the coolant is cooled through the first coolant path, and therefore, heat dissipation requirements of the power battery 610 and the charging cable 433 cannot be met.

Therefore, in embodiments of this application, when the charger 430 does not charge the electric vehicle 600, the liquid storage tank 506 may not provide coolant for the electric vehicle 600 and the liquid cooling channel 432. Correspondingly, no coolant from the electric vehicle 600 and the liquid cooling channel 432 is received through the first liquid inlet 50611 of the liquid storage tank and the second liquid inlet 50612 of the liquid storage tank. In this case, the solenoid valve 511 is turned on, so that the coolant in the liquid storage tank 506 can be cooled through the first coolant path. The coolant obtained after cooling flows back to the liquid storage tank 506 through the solenoid valve 511 again, so that the coolant in the liquid storage tank 506 maintains a low temperature.

In this way, when the charger 430 charges the electric vehicle 600, the lower-temperature coolant stored in the liquid storage tank 506 may flow, through the first liquid outlet 50610 of the liquid storage tank, into the first coolant path for cooling again, so that a temperature of the coolant flowing from the liquid storage tank 506 into the electric vehicle 600 and the liquid cooling channel 432 is lower. This helps meet heat dissipation requirements of the power battery 610 and the charging cable 433.

In some other embodiments, the liquid cooling device 500 is further configured to: when coolant is received through a liquid inlet in the first liquid inlet 50611 of the liquid storage tank and the second liquid inlet 50612 of the liquid storage tank, control the solenoid valve 511 to be turned off.

Specifically, when the charger 430 charges the electric vehicle 600, the liquid storage tank 506 provides coolant for the electric vehicle 600 and/or the liquid cooling channel 432. Correspondingly, the coolant output by the electric vehicle 600 is received through the first liquid inlet 50611 of the liquid storage tank, and/or the coolant output by the liquid cooling channel 432 is received through the second liquid inlet 50612 of the liquid storage tank. In this case, the solenoid valve 511 is turned off, so that the path between the liquid outlet 5033 of the first coolant path and the third liquid inlet 50613 of the liquid storage tank may be disconnected. That is, the circulation loop between the liquid storage tank 506 and the first coolant path is disconnected. In this way, the coolant flowing out of the first coolant path may flow only into the electric vehicle 600 and/or the liquid cooling channel 432, thereby helping ensure efficiency of heat dissipation performed by the liquid cooling device 500 on the power battery 610 and the charging cable 433.

It should be understood that, similar to the embodiments shown in FIG. 5 and FIG. 6, to improve working efficiency of the liquid storage tank 506, in the liquid storage tank 506, a liquid inlet and a liquid outlet for flowing of high-temperature coolant and a liquid inlet and a liquid outlet for flowing of low-temperature coolant may also be disposed in different chambers of the liquid storage tank 506.

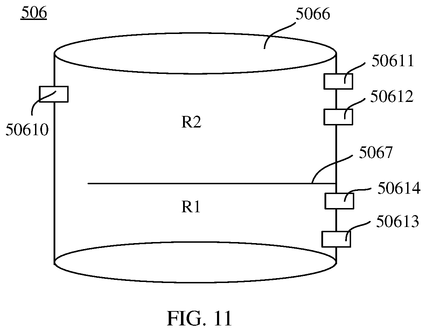

For example, refer to FIG. 11. FIG. 11 is a diagram of a specific structure of an example of the liquid storage tank 506 shown in FIG. 10.

Similar to the embodiment shown in FIG. 7, in the embodiment shown in FIG. 10, the tank body 5066 of the liquid storage tank 506 also includes a chamber R1 and a chamber R2 that communicate with each other, and the chamber R1 is located below the chamber R2 in a gravity direction. The first liquid outlet 50610 of the liquid storage tank, the first liquid inlet 50611 of the liquid storage tank, and the second liquid inlet 50612 of the liquid storage tank are located in the tank body 5066 corresponding to the chamber R2, and the first liquid outlet 50610 of the liquid storage tank, the first liquid inlet 50611 of the liquid storage tank, and the second liquid inlet 50612 of the liquid storage tank communicate with the chamber R2. The third liquid inlet 50613 of the liquid storage tank is located in the tank body 5066 corresponding to the chamber R1, and the third liquid inlet 50613 of the liquid storage tank communicates with the chamber R1.

It should be understood that the first liquid outlet 50610 of the liquid storage tank, the first liquid inlet 50611 of the liquid storage tank, and the second liquid inlet 50612 of the liquid storage tank are configured to flow coolant flowing back from the electric vehicle 600 and the liquid cooling channel 432, and the third liquid inlet 50613 of the liquid storage tank is configured to flow coolant output from the liquid outlet 5033 of the first liquid cooling channel. Therefore, temperatures of the coolant flowing through the first liquid outlet 50610 of the liquid storage tank, the first liquid inlet 50611 of the liquid storage tank, and the second liquid inlet 50612 of the liquid storage tank are higher than a temperature of the coolant flowing through the third liquid inlet 50613 of the liquid storage tank.

In other words, in the liquid storage tank 506, the liquid inlet and the liquid outlet for flowing of the low-temperature coolant communicate with the chamber R1, and the liquid inlet and the liquid outlet for flowing of the high-temperature coolant communicate with the chamber R2. In this way, the liquid inlet and the liquid outlet for flowing the high-temperature coolant in the liquid storage tank 506 are disposed above the liquid inlet and the liquid outlet for flowing the low-temperature coolant, so that mixed convection of the high-temperature coolant and the low-temperature coolant in the liquid storage tank 506 can be reduced, to reduce impact of the high-temperature coolant on the low-temperature coolant, and improve heat dissipation efficiency of the liquid cooling device 500.

For a part that is not described in detail and that is of the liquid storage tank 506, refer to the related descriptions of the embodiment shown in FIG. 7. Details are not described herein again.

Still refer to FIG. 10. In some embodiments, the liquid cooling device 500 further includes a bypass valve 512. A first valve port 5121 of the bypass valve is connected to the liquid outlet 5033 of the first coolant path, and a second valve port 5122 of the bypass valve is connected to a fourth liquid inlet 50614 of the liquid storage tank. The bypass valve 512 is configured to: when a pressure of the coolant flowing out of the liquid outlet 5033 of the first coolant path is greater than a preset pressure, connect a path between the first coolant path and the fourth liquid inlet 50614 of the liquid storage tank.

Specifically, when the pressure of the coolant flowing out of the liquid outlet 5033 of the first coolant path is high, the coolant flowing out of the liquid outlet 5033 of the first coolant path may flow back to the liquid storage tank 506 through the bypass valve 512 by connecting the path between the first valve port 5121 of the bypass valve and the second valve port 5122 of the bypass valve, to release the pressure. In this way, the pressure of the coolant distributed by the first coolant path to the electric vehicle 600 and the liquid cooling channel 432 may be maintained in a stable state, thereby improving reliability of heat dissipation performed by the liquid cooling device 500 on the power battery 610 and the charging cable 433.

In an example, the bypass valve 512 is a control valve. During specific implementation, the liquid cooling device 500 may send, to the bypass valve 512 when the pressure of the coolant flowing out of the liquid outlet 5033 of the first coolant path is greater than the preset pressure, a signal for indicating to connect the path between the first valve port 5121 of the bypass valve and the second valve port 5122 of the bypass valve.

In another example, the bypass valve 512 is a mechanical valve. During specific implementation, when the pressure of the coolant flowing out of the liquid outlet 5033 of the first coolant path is greater than the preset pressure, the path between the first valve port 5121 of the bypass valve and the second valve port 5122 of the bypass valve may be automatically connected.

It should be understood that, because the control valve needs to connect a path between different valve ports only after receiving a signal, and the mechanical valve directly connects a path between different valve ports based on the pressure of the coolant, using the mechanical valve as the bypass valve 512 helps quickly release the pressure.

It should be further understood that, in embodiments of this application, the fourth liquid inlet 50614 of the liquid storage tank is configured to flow the coolant flowing out of the liquid outlet 5033 of the first coolant path, in other words, the fourth liquid inlet 50614 of the liquid storage tank is a liquid inlet for flowing the low-temperature coolant in the liquid storage tank 506. Therefore, the fourth liquid inlet 50614 of the liquid storage tank may be disposed in the tank body 5066 corresponding to the chamber R1 shown in FIG. 11, and the fourth liquid inlet 50614 of the liquid storage tank communicates with the chamber R1.

In addition, during specific implementation, to reduce quantities of liquid inlets and liquid outlets of the liquid storage tank 506, the first liquid inlet 50611 of the liquid storage tank and the second liquid inlet 50612 of the liquid storage tank may be disposed as one liquid inlet, and the third liquid inlet 50613 of the liquid storage tank and the fourth liquid inlet 50614 of the liquid storage tank may be disposed as one liquid inlet. This can reduce structural complexity of the liquid storage tank 506 and help processing design of the liquid storage tank 506.

Still refer to FIG. 10. In some embodiments, to adjust a flow of the coolant distributed by the first coolant path to the electric vehicle 600 and the liquid cooling channel 432, the liquid cooling device 500 further includes a connection path 513 and a flow regulating valve 514. A liquid inlet of the connection path 513 is connected to the liquid outlet 5033 of the first coolant path, and a liquid outlet of the connection path 513 is configured to connect to the liquid injection port 641 of the electric vehicle and the liquid inlet 4321 of the liquid cooling channel 432. The flow regulating valve 514 is configured to be connected between the liquid outlet of the connection path 513 and the liquid injection port 641 of the electric vehicle, or the flow regulating valve 514 is configured to be connected between the liquid outlet of the connection path 513 and the liquid inlet 4321 of the liquid cooling channel 432.

For example, the flow regulating valve 514 shown in FIG. 10 is configured to be connected between the liquid outlet of the connection path 513 and the liquid inlet 4321 of the liquid cooling channel 432. The flow regulating valve 514 may adjust the flow of the coolant distributed by the connection path 513 to the liquid cooling channel 432. In addition, the flow of the coolant distributed by the connection path 513 to the electric vehicle 600 is negatively correlated with a change of the flow of the coolant distributed by the connection path 513 to the liquid cooling channel 432.

Specifically, as the flow regulating valve 514 regulates the flow of the coolant distributed by the connection path 513 to the liquid cooling channel 432 to increase, the flow of the coolant distributed by the connection path 513 to the electric vehicle 600 decreases accordingly. Alternatively, as the flow regulating valve 514 regulates the flow of the coolant distributed by the connection path 513 to the liquid cooling channel 432 to decrease, the flow of the coolant distributed by the connection path 513 to the electric vehicle 600 increases accordingly. In this way, the flow of the coolant distributed by the connection path 513 to the electric vehicle 600 and the liquid cooling channel 432 may be regulated by the flow regulating valve 514.

It should be understood that, for a part that is not described in detail and that is of the liquid cooling device 500 shown in FIG. 10 and FIG. 11, refer to the related descriptions of the embodiments shown in FIG. 5 to FIG. 9. Details are not described herein again.

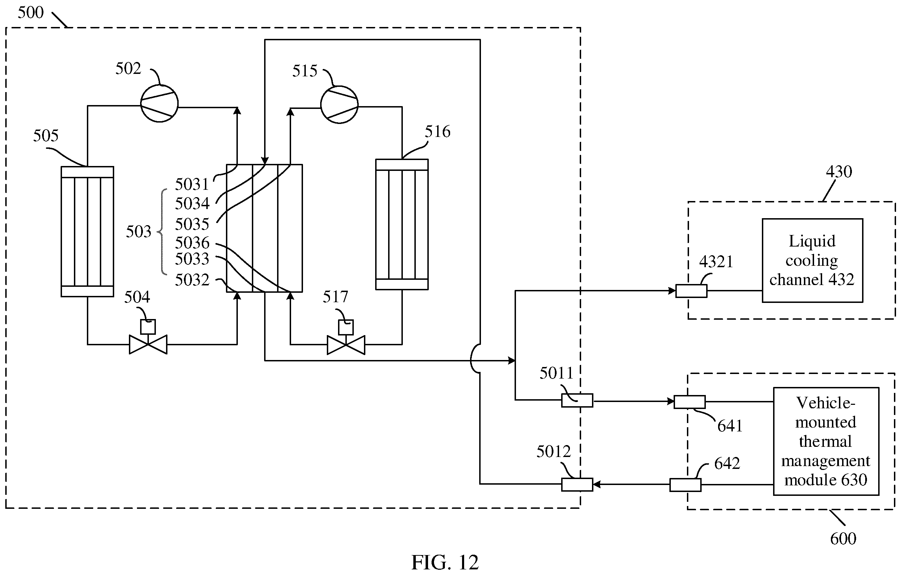

FIG. 12 is a diagram of a structure of another liquid cooling device 500 according to an embodiment of this application.

Different from the embodiments shown in FIG. 4 to FIG. 11, in the embodiment shown in FIG. 12, the liquid cooling device 500 forms two refrigerant loops by using a first heat exchanger 503.

Specifically, the liquid cooling device 500 further includes a second compressor 515, a second expansion valve 517, and a third heat exchanger 516. The second compressor 515, the first heat exchanger 503, the second expansion valve 517, and the third heat exchanger 516 are sequentially connected through a refrigerant pipeline. The first heat exchanger 503 further includes a second refrigerant path, and the second refrigerant path is connected between the second compressor 515 and the second expansion valve 517. Similar to the first refrigerant path, the second refrigerant path is also configured to exchange heat with a first coolant path.

During specific implementation, a liquid outlet 5035 of the second refrigerant path is connected to an inlet of the second compressor 515, an outlet of the second compressor 515 is connected to a liquid inlet of the third heat exchanger 516, a liquid outlet of the third heat exchanger 516 is connected to a first valve port of the second expansion valve 517 (for example, a right valve port of the second expansion valve 517 shown in FIG. 12), and a second valve port of the second expansion valve 517 (for example, a left valve port of the second expansion valve 517 shown in FIG. 12) is connected to a liquid inlet 5036 of the second refrigerant path.

Based on the foregoing design, a refrigerant circulation loop is formed among a first compressor 502, a second heat exchanger 505, a first expansion valve 504, and a first refrigerant channel of the first heat exchanger 503, another refrigerant circulation loop is formed among the second compressor 515, the third heat exchanger 516, the second expansion valve 517, and the second refrigerant path of the first heat exchanger 503. The two refrigerant loops are both configured to cool coolant flowing in a first coolant path of the first heat exchanger 503, so that heat dissipation efficiency of the coolant in the first coolant path can be improved. In this way, heat dissipation efficiency of the liquid cooling device 500 for a power battery 610 and a charging cable 433 can be improved.

For example, the third heat exchanger 516 may be a condenser.

An embodiment of this application further provides a charging pile. The charging pile includes a plurality of charging modules, a charger, and the foregoing liquid cooling device 500. The charger is configured to transfer electric energy output by the plurality of charging modules to an electric vehicle, and a liquid inlet of a liquid cooling channel of the charger is configured to receive coolant output by the liquid cooling device. For specific descriptions of the charging pile, refer to related descriptions of the embodiments shown in FIG. 2 and FIG. 3. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A liquid cooling device, wherein the liquid cooling device comprises a first compressor, a first heat exchanger, a first expansion valve, and a second heat exchanger that are sequentially connected, the first heat exchanger comprises a first refrigerant path and a first coolant path, the first refrigerant path is connected between the first compressor and the first expansion valve, and the first refrigerant path is configured to exchange heat with the first coolant path, wherein
a liquid outlet of the first coolant path is configured to connect to a liquid injection port of an electric vehicle and a liquid inlet of a liquid cooling channel of a charger, and a liquid inlet of the first coolant path is configured to connect to a liquid return port of the electric vehicle.

2. The liquid cooling device according to claim 1, wherein the liquid cooling device further comprises a liquid storage tank, and the liquid outlet of the first coolant path is configured to connect to the liquid injection port of the electric vehicle and the liquid inlet of the liquid cooling channel of the charger through the liquid storage tank; and
a first liquid inlet of the liquid storage tank is connected to the liquid outlet of the first coolant path, a first liquid outlet of the liquid storage tank is configured to connect to the liquid injection port of the electric vehicle, and a second liquid outlet of the liquid storage tank is configured to connect to the liquid inlet of the liquid cooling channel of the charger.

3. The liquid cooling device according to claim 2, wherein the liquid inlet of the first coolant path is configured to connect to a liquid outlet of the liquid cooling channel of the charger, or a second liquid inlet of the liquid storage tank is configured to connect to the liquid outlet of the liquid cooling channel of the charger.

4. The liquid cooling device according to claim 2 or 3, wherein a third liquid outlet of the liquid storage tank is connected to the liquid inlet of the first coolant path.

5. The liquid cooling device according to claim 4, wherein the liquid cooling device further comprises a three-way valve, a first valve port of the three-way valve is configured to connect to the liquid return port of the electric vehicle, a second valve port of the three-way valve is connected to the third liquid outlet of the liquid storage tank, and a third valve port of the three-way valve is connected to the liquid inlet of the first coolant path.

6. The liquid cooling device according to claim 5, wherein the three-way valve is configured to:
when no coolant is output from the first liquid outlet of the liquid storage tank and the second liquid outlet of the liquid storage tank, connect a path between the liquid inlet of the first coolant path and the third liquid outlet of the liquid storage tank, and disconnect a path between the liquid inlet of the first coolant path and the liquid return port of the electric vehicle.

7. The liquid cooling device according to any one of claims 4 to 6, wherein the liquid storage tank comprises a tank body, the tank body comprises two chambers that communicate with each other, and one of the chambers is located below the other chamber in a gravity direction, wherein
the first liquid inlet of the liquid storage tank, the first liquid outlet of the liquid storage tank, and the second liquid outlet of the liquid storage tank are located in the tank body corresponding to the one chamber, and the third liquid outlet of the liquid storage tank is located in the tank body corresponding to the other chamber.

8. The liquid cooling device according to any one of claims 4 to 6, wherein the liquid inlet of the first coolant path is configured to connect to the liquid return port of the electric vehicle through the liquid storage tank, wherein
a third liquid inlet of the liquid storage tank is configured to connect to the liquid return port of the electric vehicle, and a fourth liquid outlet of the liquid storage tank is connected to the liquid inlet of the first coolant path.

9. The liquid cooling device according to claim 8, wherein the liquid storage tank comprises two chambers, and the two chambers do not communicate with each other, wherein
the first liquid inlet of the liquid storage tank, the first liquid outlet of the liquid storage tank, the second liquid outlet of the liquid storage tank, and the third liquid outlet of the liquid storage tank communicate with one of the chambers, and the third liquid inlet of the liquid storage tank and the fourth liquid outlet of the liquid storage tank communicate with the other chamber.

10. The liquid cooling device according to claim 1, wherein the liquid cooling device further comprises a liquid storage tank, and the liquid inlet of the first coolant path is configured to connect to the liquid return port of the electric vehicle and a liquid outlet of the liquid cooling channel of the charger through the liquid storage tank; and
a first liquid outlet of the liquid storage tank is connected to the liquid inlet of the first coolant path, a first liquid inlet of the liquid storage tank is configured to connect to the liquid return port of the electric vehicle, and a second liquid inlet of the liquid storage tank is configured to connect to the liquid outlet of the liquid cooling channel of the charger.

11. The liquid cooling device according to claim 10, wherein the liquid cooling device further comprises a solenoid valve, a first valve port of the solenoid valve is connected to the liquid outlet of the first coolant path, and a second valve port of the solenoid valve is connected to a third liquid inlet of the liquid storage tank, and
the liquid cooling device is configured to:
when no coolant is received through the first liquid inlet of the liquid storage tank and the second liquid inlet of the liquid storage tank, control the solenoid valve to be turned on; or
when coolant is received through a liquid inlet in the first liquid inlet of the liquid storage tank and the second liquid inlet of the liquid storage tank, control the solenoid valve to be turned off.

12. The liquid cooling device according to claim 11, wherein the liquid storage tank comprises a tank body, the tank body comprises two chambers that communicate with each other, and one of the chambers is located below the other chamber in a gravity direction, wherein
the third liquid inlet of the liquid storage tank is located in the tank body corresponding to the one chamber, and the first liquid outlet of the liquid storage tank, the first liquid inlet of the liquid storage tank, and the second liquid inlet of the liquid storage tank are located in the tank body corresponding to the other chamber.

13. The liquid cooling device according to any one of claims 11 to 12, wherein the liquid cooling device further comprises a bypass valve, wherein
a first valve port of the bypass valve is connected to the liquid outlet of the first coolant path, and a second valve port of the bypass valve is connected to a fourth liquid inlet of the liquid storage tank; and
the bypass valve is configured to: when a pressure of the coolant flowing out of the liquid outlet of the first coolant path is greater than a preset pressure, connect a path between the liquid outlet of the first coolant path and the fourth liquid inlet of the liquid storage tank.

14. A charging pile, wherein the charging pile comprises a plurality of charging modules, a charger, and the liquid cooling device according to any one of claims 1 to 13, wherein
the charger is configured to transfer electric energy output by the plurality of charging modules to an electric vehicle, and a liquid cooling channel of the charger is configured to receive coolant output by the liquid cooling device.

15. The charging pile according to claim 14, wherein the charging pile further comprises a switch and a fourth heat exchanger, and output ends of the plurality of charging modules are connected to the charger through the switch;
the fourth heat exchanger comprises a first gas path and a second coolant path, and the second coolant path is configured to exchange heat with the first gas path;
an inlet of the first gas path and an outlet of the first gas path communicate with an environment in which the switch is located; and
a liquid inlet of the second coolant path is configured to receive the coolant output by the liquid cooling device.
